(19) Europäisches Patentamt
European Patent Office
Office européen des brevets

(11) Veröffentlichungsnummer: **0 182 745**
**B1**

(12) **EUROPÄISCHE PATENTSCHRIFT**

(45) Veröffentlichungstag der Patentschrift: **22.11.90**

(51) Int. Cl.$^5$: **C 08 G 73/10,** C 07 C 229/52

(21) Anmeldenummer: **85810528.1**

(22) Anmeldetag: **11.11.85**

(54) **Polyimide, Verfahren zu deren Herstellung und deren Verwendung.**

(30) Priorität: **16.11.84 CH 5487/84**

(43) Veröffentlichungstag der Anmeldung:
**28.05.86 Patentblatt 86/22**

(45) Bekanntmachung des Hinweises auf die Patenterteilung:
**22.11.90 Patentblatt 90/47**

(84) Benannte Vertragsstaaten:
**BE CH DE FR GB IT LI NL SE**

(56) Entgegenhaltungen:
**GB-A-1 140 610**
**US-A-3 726 831**
**US-A-4 131 730**

(73) Patentinhaber: **CIBA-GEIGY AG**
**Klybeckstrasse 141**
**CH-4002 Basel (CH)**

(72) Erfinder: **Pfeifer, Josef, Dr.**
**Brunnmattstrasse 32**
**CH-4106 Therwil (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 182 745 B1

**Beschreibung**

Die vorliegende Erfindung betrifft Homo- und Copolyimide aus substituierten aromatischen Aminodicarbonsäuren, aromatischen Tetracarbonsäuren und Diaminen und/oder unsubstituierten aromatischen Aminodicarbonsäuren, ein Verfahren zu deren Herstellung und deren Verwendung zur Herstellung von Schutzfilmen oder photographischen Reliefabbildungen.

Polyimide sind Kunststoffe mit wertvollen thermomechanischen Eigenschaften. Auf Grund ihrer hohen Schmelzbereiche können sie jedoch nicht mit den für Thermoplaste üblichen Formgebungsverfahren verarbeitet werden. Es sind daher lösliche Polyimide entwickelt worden, die als Lacke zur Bildung von Ueberzugsschichten mit hoher Wärmebeständigkeit verwendet werden können, vgl. DE—AS—19 62 588 und US—PS—3,787,367. Mit der Entwicklung der Elektronik und Halbleitertechnologie werden an Polyimide z.B. als Isolier- und Schutzfilme hohe Anforderungen an deren Thermostabilität gestellt, welche die bekannten Polyimide nicht immer zu erfüllen vermögen.

In der GB—PS—1,140,610 werden koalisierbare Polyimidpulver unter Verwendung eines unsubstituierten aromatischen Aminodicarbonsäuremonoesters hergestellt, die durch Anwendung von Druck und Hitze verarbeitbar sind, wobei die Polyimide unterhalb ihres kristallinen Schmelzpunktes zu fliessen beginnen. Hierfür sind Drücke von 3000 bis 100 000 psi ($20{,}7 \cdot 10^6$ — $6{,}895 \cdot 10^8$ Pa) und Temperaturen von 200° bis 500°C erforderlich.

In der US—PS—3,726,831 werden Polyimide aus neuen Aminodicarbonsäuren oder deren Estern hergestellt. Zur analytischen Infrarotspektroskopie werden keine Lösungen sondern Polyimidpulver eingesetzt. Für die Herstellung von Formkörpern, Beschichtungen oder Imprägnierungen werden nicht die Polyimide, sondern deren lösliche Zwischenprodukte eingesetzt. Die Imidisierung wird erst bei der Weiterverarbeitung durchgeführt, beispielsweise bei der Herstellung von Formstoffen oder Beschichtungen durch Anwendung von Hitze und gegebenenfalls Druck.

Es wurde nun gefunden, dass man lösliche und autophotovernetzbare Polyimide mit hoher Thermostabilität erhält, wenn sie Strukturelemente einer durch Alkyl oder Aralkyl substituierten aromatischen Aminoketodicarbonsäure enthält.

Ein Gegenstand vorliegender Erfindung sind Homo- und Copolyimide, die Strukturelemente von aromatischen Aminodicarbonsäuren enthalten, mit einer inhärenten Viskosität von mindestens 0,1 dl/g, gemessen bei 25°C in einer Lösung von 0,5 Gewichtsprozent Polyimid in N-Methylpyrrolidon, die dadurch gekennzeichnet sind, dass sie lösbar und autophotovernetzbar sind und wiederkehrende Strukturelemente der Formel I enthalten,

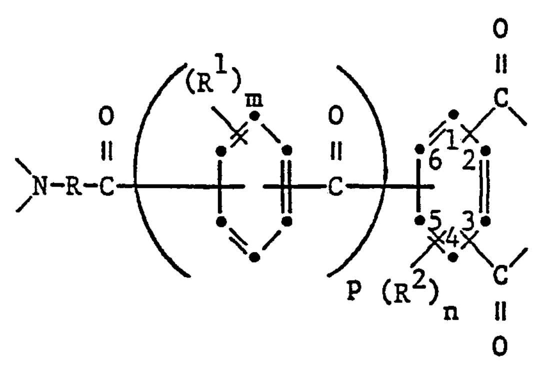

(I)

worin

$R^1$ und $R^2$ für Halogen, Nitro, Aryl, Aryloxy, Alkyl oder Alkoxy stehen, m 0 oder eine Zahl von 1—4, n 0 oder eine Zahl von 1 bis 3 und p 0, 1 oder 2 bedeuten, die freien Carbonylgruppen in Orthostellung zueinander gebunden sind, und R einen zweiwertigen aromatischen Rest bedeutet, der durch mindestens eine Alkylgruppe oder Aralkylgruppe substituiert ist.

Die inhärente Viskosität beträgt bevorzugt mindestens 0,2 dl/g, insbesondere 0,2 bis 2,0 dl/g. In Formel I stehen m, n und p bevorzugt für 0.

$R^1$ und $R^2$ sind als Halogen bevorzugt F oder Cl, als Aryl Phenyl, als Aryloxy Phenoxy und enthalten als Alkyl und Alkoxy bevorzugt 1 bis 12, besonders 1 bis 4 C-Atome. Beispiele sind Methyl, Ethyl, n-Propyl, i-Propyl, Butyl, Methoxy und Ethoxy. Die Carbonylgruppen sind vorzugsweise in 2-, 3- und 6-Stellung gebunden.

Der aromatische Rest R ist bevorzugt in mindestens einer, besonders in beiden Orthostellungen zum N-Atom durch Alkyl oder Aralkyl substituiert. Der Substituent ist als Aralkyl besonders Benzyl. Als Alkyl enthält der Substituent bevorzugt 1 bis 12, besonders 1 bis 4 C-Atome. Das Alkyl kann linear oder verzweigt sein. Besonders bevorzugt sind Aethyl, Methyl, Ethyl und Isopropyl. Weitere Beispiele sind n-Propyl, n-Butyl, Isobutyl, Pentyl, Hexyl, Octyl, Decyl und Dodecyl.

Der aromatische Rest R ist bevorzugt ein durch Alkyl substituierter Phenylenrest oder Bisphenylenrest. Insbesondere entspricht der Rest R der Formel II

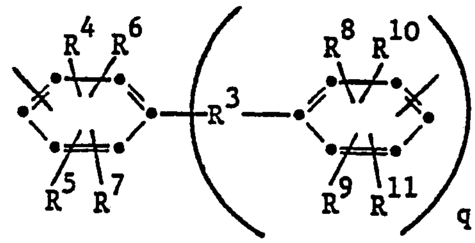

(II) ,

worin q 0 oder 1 ist, $R^3$ eine direkte Bindung oder einen Brückengruppe bedeutet, $R^4$ Alkyl mit 1 bis 4 C-Atomen und $R^5$ bis $R^{11}$ ein Wasserstoffatom oder Alkyl mit 1 bis 4 C-Atomen sind, und die freien Bindungen in Meta- oder Parastellung zur $R^3$-Gruppe gebunden sind.

In einer Ausführungsform sind $R^4$ und $R^5$ sowie $R^{10}$ und $R^{11}$ in Orthostellung zur freien Bindung gebunden und bedeuten $C_1$—$C_4$-Alkyl. In einer besonders bevorzugten Ausführungsform steht q in Formel II für 0 und $R^4$ bis $R^7$ für $C_1$—$C_4$-Alkyl, besonders Methyl oder Ethyl.

Die Brückengruppe $R^3$ kann die gleiche Bedeutung wie $R^{13}$ haben. Bevorzugt ist $R^3$ eine direkte Bindung, —S—, —O—, —SO—, —$SO_2$—, —CO— $CH_2$ oder $C_2$—$C_6$-Alkyliden, wie z.B. Ethyliden, 1,1- oder 2,2-Propyliden, Butyliden, Cyclopentyliden und Cyclohexyliden.

In einer besonderen Ausführungsform enthalten die erfindungsgemässen Polyimide Strukturelemente der Formel

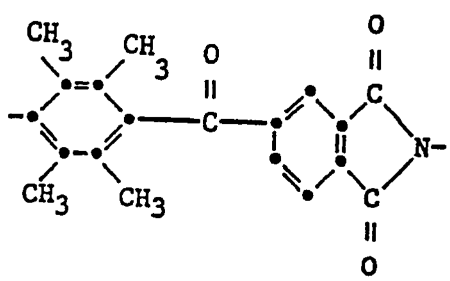

.

In einer anderen Ausführungsform enthalten die lösbare und autophotovernetzbaren Polyimide
a) 0,1—100 Mol-% Strukturelemente der Formel I und
b) 99,9—0 Mol-% Strukturelemente der Formel III und/oder IIIa

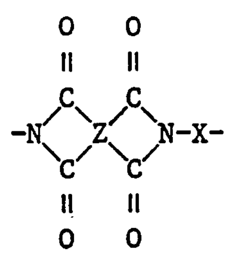

(III)

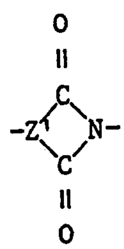

(IIIa)

worin Z der vierwertige Rest einer aromatischen Tetracarbonsäure darstellt, an den je zwei Carbonylgruppen in Ortho- oder Peristellung gebunden sind, Z' der dreiwertige von Strukturelementen der Formel I verschiedene Rest einer aromatischen Aminocarbonsäure ist, an den zwei Carbonylgruppen in Ortho- oder Peristellung gebunden sind, und X der zweiwertige Rest eines organischen Diamines ist.

Die Strukturelemente der Formel I sind bevorzugt in einer Menge von 5—100 Mol-%, bevorzugter 20—100 Mol-%, besonders 50—100 Mol-% und insbesondere 80—100 Mol-% und die Strukturelemente der Formel III bzw. IIIa bevorzugt in einer menge von 95—0 Mol-%, bevorzugter 80 bis 0 Mol-%, besonders 50 bis 0 Mol-% und insbesondere 20 bis 0 Mol-% enthalten.

X in Formel III kann ein zweiwertiger unsubstituierter oder substituierter aliphatischer Rest, der durch Heteroatome, aromatische, heterocyclische oder cycloaliphatische Gruppen unterbrochen sein kann, ein unsubstituierter oder substituierter, heterocyclischer, cycloaliphatischer oder araliphatischer Rest, ein aromatischer Rest, bei dem zwei Arylkerne über eine aliphatische Gruppe verknüpft sind, oder ein durch mindestens eine Alkylgruppe, Cycloalkylgruppe, Alkoxyalkylgruppe, Alkoxygruppe, Alkylthiogruppe, Alkylthioalkylgruppe, Hydroxyalkylgruppe, Hydroxyalkoxygruppe, Hydroxyalkylthiogruppe, Aralkylgruppe oder zwei benachbarte C-Atome des aromatischen Restes durch eine Alkylengruppe substituierter aromatischer Rest, sein.

Bevorzugter ist X Alkylen, Cycloalkylen, Aralkylen oder Arylen, besonders substituiertes Arylen.

X in Formel III in der Bedeutung als zweiwertiger aliphatischer Rest enthält bevorzugt 2 bis 30, besonders 6 bis 30 und insbesondere 6 bis 20 C-Atome. In einer bevorzugten Untergruppe is X lineares oder verzweigtes Alkylen, das durch Sauerstoffatome, S, SO, $SO_2$, NH, $NR^a$, $^{\oplus}NR^a_2G^{\ominus}$, Cyclohexylen, Naphthylen, Phenylen oder Hydantoinreste unterbrochen sein kann. $R^a$ kann z.B. Alkyl mit 1 bis 12 C-Atomen oder Cycloalkyl mit 5 oder 6 Ring-C-Atomen, Phenyl oder Benzyl sein. $G^{\ominus}$ bedeutet ein Anion einer Protonensäure, z.B. Halogenid, Sulfat, Phosphat. In einer bevorzugten Ausführungsform sind R bzw. R' lineares oder verzweigtes Alkylen mit 6 bis 30 C-Atomen, $-(CH_2)_{m'}-R^{14}-(CH_2)_{n'}-$, worin $R^{14}$ Phenylen, Naphthylen, Cyclopentylen oder Cyclohexylen und m' und n' unabhängig voneinander die Zahl 1, 2 oder 3 sind, $-R^{15}-(OR^{16})_p-O-R^{15}-$, worin $R^{15}$ Aethylen, 1,2-Propylen, 1,3-Propylen oder 2-Methyl-1,3-propylen und $R^{16}$ Aethylen, 1,2-Propylen, 1,2-Butylen, 1,3-Propylen oder 1,4-Butylen und p eine Zahl von 1 bis 100 sind, oder

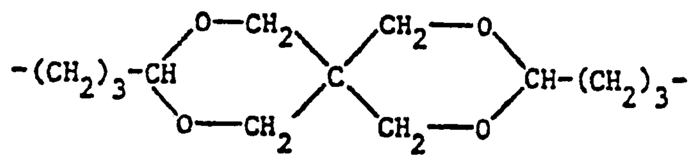

.

Beispiele für aliphatische Reste sind: Methylen, Aethylen, 1,2- oder 1,3-Propylen, 2,2-Dimethyl-1,3-propylen, 1,2-, 1,3- oder 1,4-Butylen, 1,3- oder 1,5-Pentylen, Hexylene, Heptylene, Octylene, Decylene, Dodecylene, Tetradecylene, Hexadecylene, Octadecylene, Eicosylene, 2,4,4-Trimethylhexylen, 1,10-Dialkyldecylen, wobei das Alkyl bevorzugt 1- bis 6 C-Atome aufweist, substituierte 1,11-Undecylene, wie sie z.B. in der EP—B—0 011 559 beschrieben sind, Jeffamine wie z.B.

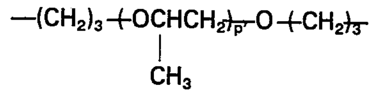

mit p' = 1 bis 100 oder

$-(CH_2)_3-(O(CH_2)_4)_{p'}-O-(CH_2)_3$ mit p' = 1—100, Dimethylencyclohexan, Xylylen und Diäthylbenzol. Besonders bevorzugt ist X längerkettiges, verzweigtes Alkylen mit z.B. 8 bis 30 C-Atomen.

X in Formel I kann als aliphatischer Rest auch einem Polysiloxanrest der Formel

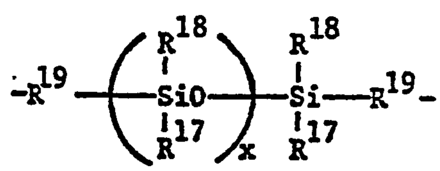

bedeuten, worin $R^{18}$ und $R^{17}$ $C_1$—$C_6$-Alkyl, besonders Methyl, oder Phenyl sind, $R^{19}$ Cycloalkylen wie z.B. Cyclohexylen und besonders $C_1$—$C_{12}$, insbesondere $C_1$—$C_6$-Alkylen, z.B. 1,3-Propylen oder 1,4-Butylen, ist, und x für eine rationale Zahl von mindestens 1, z.B. 1 bis 100, bevorzugt 1 bis 10 steht. Solche Diamine mit diesem Rest sind in der US—PS—3 435 002 und US—PS—4 030 948 beschrieben.

Bei den durch heterocyclische Reste unterbrochenen aliphatischen Resten kann es sich z.B. um solche handeln, die sich von N,N'-aminoalkylierten Hydantoinen oder Benzimidazolen ableiten. Beispiele sind, N,N'-(γ-Aminopropyl)-5,5-dimethyl-hydantoin oder -benzimidazolon und solche der Formel

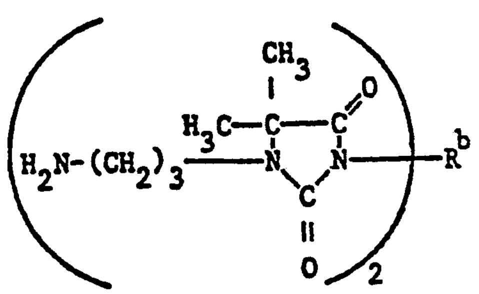

,

worin $R^b$ Alkylen mit 1 bis 12, bevorzugt 1 bis 4 C-Atomen oder

$$-(CH_2\underset{\displaystyle R^c}{\underset{|}{C}}HO)_aCH_2CH_2$$

ist, worin $R^c$ ein Wasserstoffatom oder Methyl und a ganze Zahlen von 1—20 bedeuten.

Geeignete Substituenten für die aliphatischen Reste sind z.B. Hydroxyl, Halogenid wie F oder Cl oder Alkoxy mit 1 bis 6 C-Atomen.

Heterocyclische Diaminreste leiten sich bevorzugt von N-heterocyclischen Diaminen ab, z.B. von Pyrrolidin, Indol, Piperidin, Pyridin, Pyrrol, deren N-Atom alkyliert, z.B methyliert, sein kann. Ein Beispiel ist N-Methyl-4-amino-5-aminomethylpiperidin.

X in Formel I in seiner Bedeutung als zweiwertiger cycloaliphatischer Rest enthält bevorzugt 5 bis 8 Ring-C-Atome und ist besonders unsubstituiertes oder mit Alkyl, das vorzugsweise 1 bis 4 C-Atome enthält, substituiertes ein- oder zweikerniges Cycloalkylen mit 5 bis 7 Ring-C-Atomen. In einer bevorzugten Ausführungsform ist X als cycloaliphatischer Rest ein solcher der Formeln

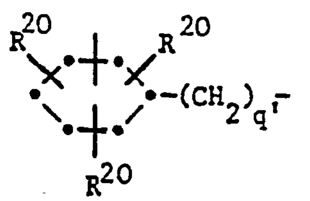 oder 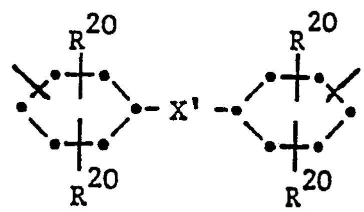 ,

worin q' 0 oder 1 ist, die $R^{20}$ unabhängig Wasserstoff oder Alkyl mit 1 bis 6 C-Atomen bedeuten und X' für eine direkte Bindung, O, S, $SO_2$, Alkylen mit 1 bis 3 C-Atomen oder Alkyliden mit 2 bis 6 C-Atomen steht. $R^{20}$ ist bevorzugt Aethyl oder Methyl, X' bevorzugt Methylen und das Alkyliden enthält bevorzugt 2 oder 3 C-Atome, wie Aethyliden und 1,1- oder 2,2-Propyliden.

Beispiele für X als Cycloalkylen sind: 1,2- oder 1,3-Cyclopentylen, 1,2-, 1,3- oder 1,4-Cyclohexylen, Cycloheptylen, Cyclooctylen, Methylcyclopentylen, Methyl- oder Dimethylcyclohexylen, 3- oder 4-Methylcyclohex-1-yl, 5-Methyl-3-methylencyclohex-1-yl, 3,3'- oder 4,4'-Bis-cyclohexylen, 3,3'-Dimethyl-4,4'-biscyclohexylen, 4,4'-Biscyclohexylenäther oder -sulfon oder -methan oder -2,2-propan, sowie die Reste von Bis-aminomethyltricyclodecan, Bis-aminomethylnorbornan und Menthandiamin.

Besonders bevorzugt ist X als cycloaliphatischer Rest 1,4- oder 1,3-Cyclohexylen, 2,2,6-Trimethyl-6-methylen-cyclohex-4-yl, Methylenbis(cyclohex-4-yl) oder Methylenbis(3-methylcyclohex-4-yl).

X als araliphatischer Rest enthält bevorzugt 7 bis 30 C-Atome. Sofern die aromatische Gruppe des araliphatischen Restes an die N-Atome im Rest der Formel III gebunden ist, was bevorzugt ist, so sind diese aromatischen Gruppen bevorzugt so substituiert wie X als aromatischer Rest, einschliesslich der Bevorzugungen. Der araliphatische Rest enthält bevorzugt 7 bis 30, besonders 8 bis 22 C-Atome. Der aromatische Rest im araliphatischen Rest ist bevorzugt ein Phenylrest. In seiner Bedeutung als araliphatischer Rest bedeutet X besonders unsubstituiertes oder am Aryl durch Alkyl substituiertes Aralkylen, wobei der Alkylenrest linear oder verzweigt ist. In einer bevorzugten Ausführungsform entspricht der araliphatische Rest der Formel

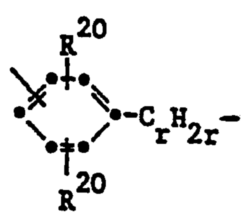

worin die $R^{20}$ unabhängig voneinander ein Wasserstoffatom oder besonders Alkyl mit 1—6 C-Atomen und r ganze Zahlen von 1—20 bedeuten.

Die freie Bindung kann sich in o-Stellung, m-Stellung und besonders in p-Stellung zur $C_rH_{2r}$-Gruppe befinden und eine oder beide $R^{20}$ sind bevorzugt in o-Stellung zur freien Bindung gebunden.

Beispiele für X als araliphatischer Rest sind: m- oder p-Benzylen, 3-Methyl-p-benzylen, 3-Aethyl-p-Benzylen, 3,5-Dimethyl-p-benzylen, 3,5-Diäthyl-p-benzylen, 3-Methyl-5-äthyl-p-benzylen, p-Phenylen-propylen, 3-Methyl-p-phenylen-propylen, p-Phenylenbutylen, 3-Aethyl-p-phenylenpentylen sowie insbesondere längerkettige Phenylenalkylenreste, die z.B. in der EP—A—0 069 062 beschrieben sind: 6 - (p - Phenylen) - 6 - methylhept - 2 - yl, 6 - (3' - Methyl - p - phenylen) - 6 - methylhept - 2 - yl, 6 - (3' - Aethyl - p - phenylen) - 6 - methylhept - 2 - yl, 6 - (3',5' - Dimethyl - p - phenylen) - 6 - methylhept - 2 - yl, 11 - (p - Phenylen) - 2,11 - dimethyl - dodec - 1 - yl, 13 - (p - Phenylen) - 2,12 - dimethyltetradec-3 - yl.

X kann auch ein aromatischer Rest sein, bei dem zwei Arylkerne, besonders Phenyl über eine aliphatische Gruppe verknüpft sind. Dieser Rest entspricht bevorzugt der Formel

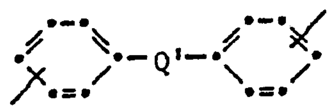

worin die freien Bindungen in p-, m- und besonders o-Stellung zur Q'-Gruppe gebunden sind und Q' $C_1$—$C_{12}$—, besonders $C_1$—$C_6$-Alkylen ist, das durch O oder S unterbrochen sein kann. Beispiele für Q' sind Aethylen, 1,2- oder 1,3-Propylen, Butylen, —$CH_2$—O—$CH_2$, —$CH_2$—S—$CH_2$— und —$CH_2CH_2$—O—$CH_2CH_2$—.

Unter den Copolyimiden sind besonders solche mit Strukturelementen der Formel III bevorzugt, worin X substituierte aromatische Reste bedeutet. Der Substituent am aromatischen Rest enthält bevorzugt 1 bis 20, besonders 1—12 und insbesondere 1—6 C-Atome. Insbesondere ist der Substituent $C_5$- oder $C_6$-Cycloalkyl, lineares oder verzweigtes Alkyl, Alkoxy, Alkoxyalkyl, Alkylthio, Alkylthioalkyl, Hydroxyalkyl, Hydroxyalkoxy oder Hydroxyalkylthio mit 1 bis 6 C-Atomen, Benzyl, Trimethylen oder Tetramethylen. Als Alkoxyalkyl ist Alkoxymethyl bevorzugt und als Alkoxy Methoxy. Beispiele für den Substituenten sind: Methyl, Aethyl, Propyl, Isopropyl, n-Butyl, Isobutyl, Pentyl, Hexyl, Octyl, Dodecyl, Tetradecyl, Eicosyl, Methoxy, Aethoxy, Propoxy, Butoxy, Pentoxy, Hexoxy, Methoxymethyl, Methoxyäthyl, Aethoxymethyl, Propoxymethyl, Butoxymethyl, Benzyl, Methylbenzyl, Phenyläthyl, Methylthio, Aethylthio, Hydroxyäthyl, Methylthioäthyl und Hydroxyäthylthio. Bevorzugte Reste sind Methoxymethyl, Aethoxymethyl, Methyl, Aethyl, n-Propyl, i-Propyl, Trimethylen und Tetramethylen, Cyclopentyl und Cyclohexyl. Besonders bevorzugt ist Methyl, Aethyl und i-Propyl. Bei dem substituierten aromatischen Rest kann es sich um einkernige oder mehrkernige, besonders zweikernige Reste handeln. Einkernige Reste können 1 bis 4, bevorzugt 1 oder 2. Substituenten enthalten und zweikernige Reste können bis zu 4, bevorzugt 1 oder 2 Substituenten in jedem Kern enthalten. Es wurde gefunden, dass die Lichtempfindlichkeit von Copolyimiden hoch ist, wenn ein oder zwei Substituenten in Orthostellung zum N-Atom gebunden sind. Die Substitution in Orthostellung ist daher bevorzugt. Der aromatische Rest ist bevorzugt in Meta- oder Parastellung zum N-Atom gebunden.

X kann als substituierter aromatischer Rest 7 bis 30, besonders 7 bis 20 C-Atome enthalten. Der aromatische Rest ist bevorzugt ein Kohlenwasserstoffrest wie z.B. Phenylen, Naphthylen oder Bisphenylene oder Pyridinrest, die wie zuvor definiert substituiert sind.

Eine bevorzugte Untergruppe sind solche aromatische Reste der Formeln

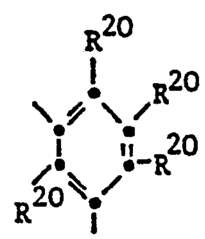 , 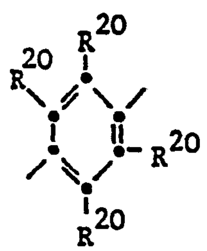 , 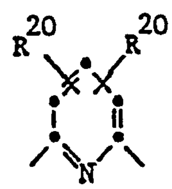 ,

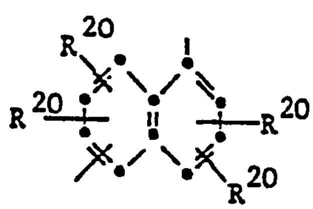 , 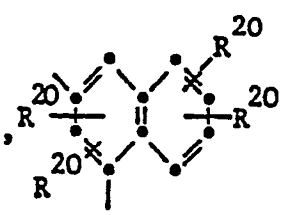 , 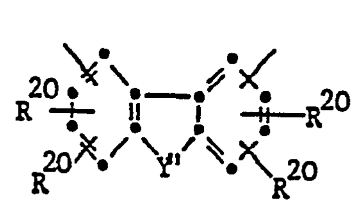 ,

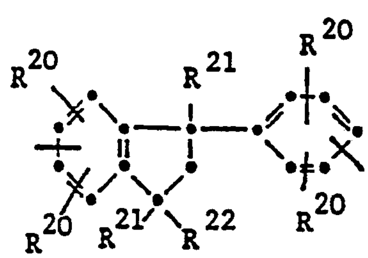 oder 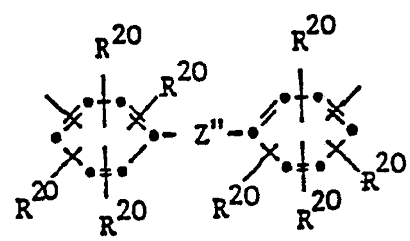 ,

worin $R^{20}$ im Falle der Monosubstitution Alkyl mit 1 bis 6 C-Atomen und die anderen $R^{20}$ Wasserstoff sind,

und im Falle der Di-, Tri- oder Tetrasubstitution zwei $R^{20}$ Alkyl mit 1 bis 6 C-Atomen und die anderen $R^{20}$ ein Wasserstoffatom oder Alkyl mit 1 bis 6 C-Atomen sind oder im Falle der Di-, Tri- oder Tetrasubstitution zwei vicinale $R^{20}$ im Phenylring für Trimethylen oder Tetramethylen und die anderen $R^{20}$ für ein Wasserstoffatom oder Alkyl mit 1 bis 6 C-Atomen stehen, Y'' für O, S, NH, CO oder $CH_2$ steht, $R^{21}$ ein Wasserstoffatom oder Alkyl mit 1 bis 5 C-Atomen und $R^{22}$ Alkyl mit 1 bis 5 C-Atomen darstellt, und Z'' eine direkte Bindung, O, S, SO, $SO_2$, CO,

$\overset{\overset{O}{\|}}{C}O$, $\overset{\overset{O}{\|}}{C}NR^{23}$, $NR^{23}$, CONH, NH, $R^{23}SiR^{24}$, $R^{23}OSiOR^{24}$, 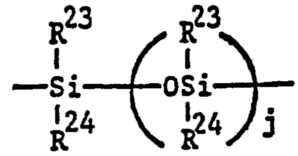

Alkylen mit 1 bis 6 C-Atomen, das durch —O— oder —S— unterbrochen sein kann, Alkenylen oder Alkyliden mit 2 bis 6 C-Atomen, Phenylen oder Phenyldioxyl bedeutet, worin $R^{23}$ und $R^{24}$ unabhängig voneinander Alkyl mit 1 bis 6 C-Atomen, oder Phenyl bedeuten und j für 1—10, besonders 1—3 steht. Z'' kann weiter der Formel

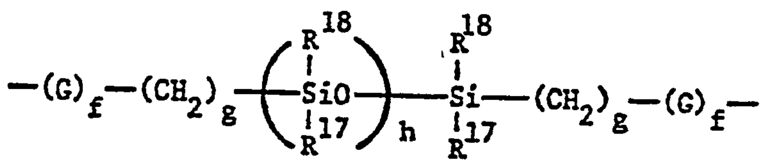

entsprechen worin G für S und besonders für 0 steht, f 0 oder besonders 1, g 1—6 und h 1 bis 50, besonders 1 bis 10 bedeuten, und $R^{18}$ und $R^{17}$ die zuvor angegebene Bedeutung haben, sowie einen Rest der Formel

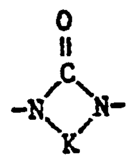

entsprechen worin K für

$-\overset{\overset{O}{\|}}{C}-\overset{\overset{O}{\|}}{C}-$, $-\overset{\overset{R^{25}}{|}}{C}R^{25}-\overset{\overset{O}{\|}}{C}-$ oder $-\overset{\overset{O}{\|}}{C}-\overset{\overset{R^{25}}{|}}{N}-\overset{\overset{O}{\|}}{C}$

mit $R^{25}$ gleich H, $C_1$—$C_6$-Alkyl oder Phenyl steht. $R^{21}$ und $R^{22}$ sind bevorzugt Methyl, Y'' steht bevorzugt für —$CH_2$— oder —O— und Z'' bevorzugt für eine direkte Bindung, —O—, —$CH_2$— oder Alkyliden mit 2 bis 4 C-Atomen, $R^{23}$ und $R^{24}$ stehen besonders für Methyl, Aethyl und Phenyl. Das Alkylen enthält bevorzugt 2 bis 4 C-Atome und ist besonders Aethylen. Alkenylen ist besonders Aethenylen.

Eine bevorzugte Untergruppe sind Toluylenreste, Reste O,O'-substituierter Diaminodiphenylene, Diaminodiphenylmethane und Diaminodiphenyläther.

Eine besonders bevorzugte Gruppe sind solche aromatischen Reste der Formeln

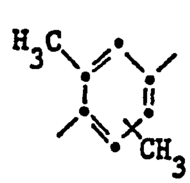 , 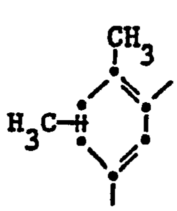 , 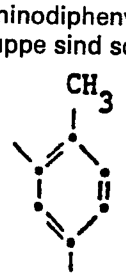 , 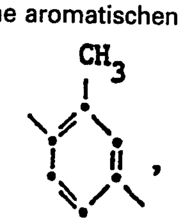 , 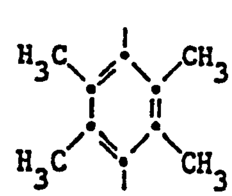 , 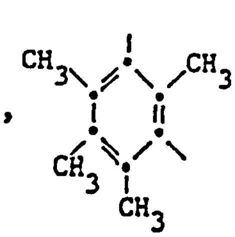

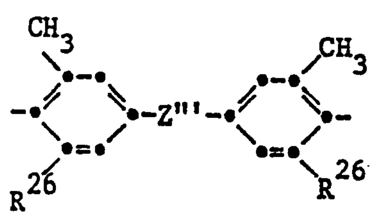 , 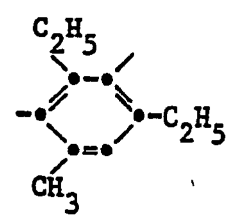 oder 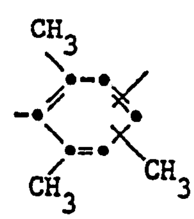

worin Z''' eine direkte Bindung, O und besonders $CH_2$ bedeutet und $R^{26}$ eine Wasserstoffatom, Methyl, Aethyl oder Isopropyl darstellt.

Beispiele für substituierte aromatische Reste X sind: 4-Methyl-1,3-phenylen, 4-Aethyl-1,3-phenylen, 2-Methyl-1,3-phenylen, 4-benzyl-1,3-phenylen, 4-Methoxymethyl-1,3-phenylen, Tetrahydro-1,3- oder -1,4-naphthylen, 3-Propyl-1,3- oder -1,4-phenylen, 3-Isopropyl-1,4-phenylen, 3,5-Dimethyl-1,4-phenylen, 2,4-Dimethyl-1,3-phenylen, 2,3-Dimethyl-1,4-phenylen, 5-Methyl-1,3-phenylen, 2,3,5,6-Tetramethyl-1,4- oder -1,3-phenylen, 3-Methyl-2,6-pyridylen, 3,5-Dimethyl-2,6-pyridylen, 3-Aethyl-2,6-pyridylen, 1-Methyl-2,7-naphthylen, 1,6-Dimethyl-2,7-naphthylen,

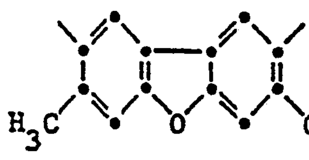,
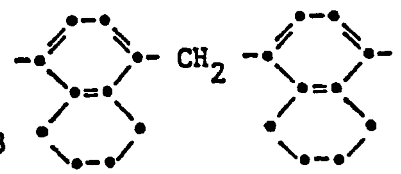,
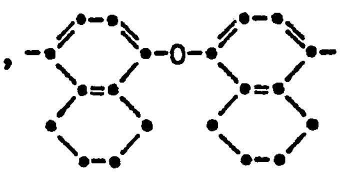,

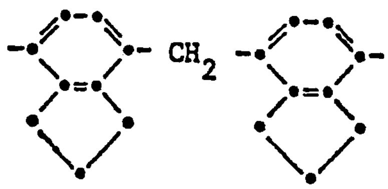,
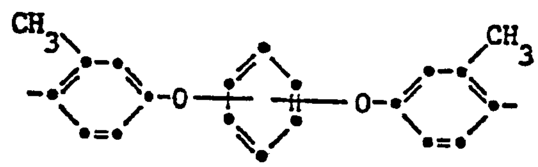

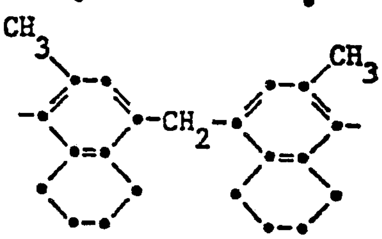,
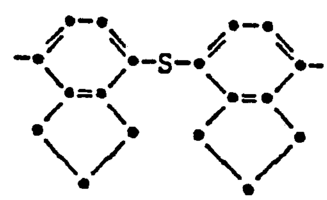,

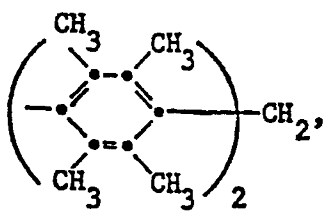
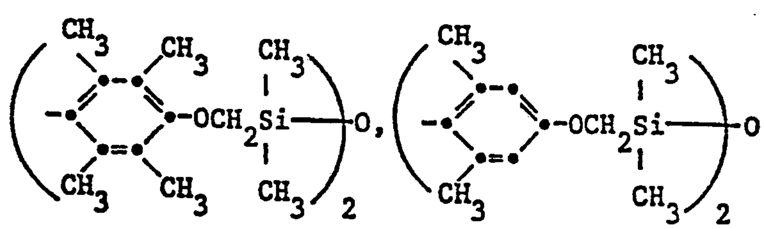,

sowie

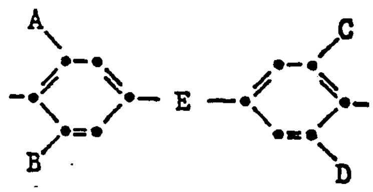,
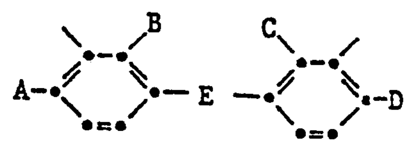,

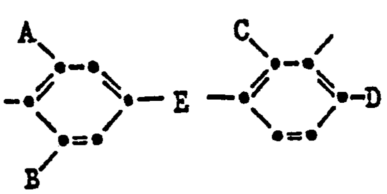,
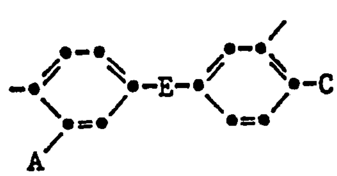 und
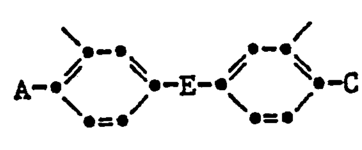

worin A, B, C, D und E die in nachfolgender Tabelle angegebenen Bedeutungen haben. Die freien Positionen in den Phenylkernen können hierbei durch einen oder zwei weitere Substituenten G oder H in jedem Kern besetzt sein, wobei G oder H die in nachfolgender Tabelle angegebene Bedeutung von A bis D haben können:

| E | A | B | C | D |
|---|---|---|---|---|
| $CH_2$ | Methyl | Methyl | H | H |
| $CH_2$ | Methyl | Aethyl | H | H |
| $CH_2$ | Aethyl | Aethyl | H | H |
| $CH_2$ | Isopropyl | Isopropyl | H | H |
| $CH_2$ | Methoxymethyl | | H | H |
| $CH_2$ | Benzyl | Benzyl | H | H |
| $CH_2$ | Methyl | Methyl | Methyl | H |
| $CH_2$ | Aethyl | Aethyl | Aethyl | H |
| $CH_2$ | Isopropyl | Isopropyl | Methyl | Methyl |
| $CH_2$ | Methoxymethyl | | Methyl | H |
| $CH_2$ | Methyl | Aethyl | Methyl | H |
| $CH_2$ | Methoxymethyl | | Methoxymethyl | |
| $CH_2$ | Methyl | Methyl | Methyl | Methyl |
| $CH_2$ | Aethyl | Aethyl | Aethyl | Aethyl |
| $CH_2$ | Methyl | Methyl | Aethyl | Aethyl |
| $CH_2$ | Aethyl | Aethyl | Isopropyl | Isopropyl |
| $CH_2$ | Isopropyl | Isopropyl | Isopropyl | Isopropyl |
| $CH_2$ | Isopropyl | Isopropyl | Methyl | H |
| $CH_2$ | Methoxy | Methoxy | Methyl | Methyl |
| O | Methyl | Methyl | H | H |
| O | Aethyl | Aethyl | H | H |
| O | Methyl | Methyl | Methyl | H |
| O | Methyl | Methyl | Methyl | Methyl |
| O | Methyl | Methyl | Aethyl | Aethyl |
| S | Methyl | Methyl | H | H |
| S | Aethyl | Aethyl | H | H |
| S | Methyl | Methyl | H | H |
| S | Methyl | Methyl | Methyl | Methyl |
| S | Aethyl | Aethyl | Aethyl | Aethyl |
| S | Methyl | Methyl | Aethyl | Aethyl |
| CO | Methyl | Methyl | Methyl | H |

| E | A | B | C | D |
|---|---|---|---|---|
| CO | Methyl | Methyl | H | H |
| CO | Methyl | Methyl | Methyl | Methyl |
| $SO_2$ | Methyl | Methyl | Aethyl | H |
| $SO_2$ | Methyl | Methyl | H | H |
| $SO_2$ | Methyl | Methyl | Methyl | Methyl |
| $SO_2$ | Aethyl | Aethyl | Methyl | Methyl |
| SO | Methyl | Methyl | Methyl | Methyl |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |
| $NCH_3$ | Methyl | Methyl | Aethyl | Aethyl |
| $NCH_3$ | Methyl | Methyl | Methyl | Methyl |
| CONH | Methyl | Methyl | — | — |
| NH | Aethyl | Methyl | Aethyl | Methyl |
| NH | Methyl | Methyl | Methyl | Methyl |
| Si(Methyl)$_2$ | Methyl | Methyl | H | H |
| Si(Phenyl)$_2$ | Methyl | Methyl | Methyl | Methyl |
| Si(OMethyl)$_2$ | Aethyl | Aethyl | H | H |
| Si(OPhenyl)$_2$ | Methyl | Methyl | Methyl | Methyl |
| —OSi(Methyl)$_2$O— | Methyl | Methyl | Methyl | Methyl |
| Aethylen | Methyl | Methyl | H | H |
| Aethylen | Methyl | Methyl | Methyl | Methyl |
| Aethylen | Aethyl | Aethyl | H | H |
| Aethylen | Methyl | Methyl | Aethyl | Aethyl |
| Phenylen | Methyl | Methyl | Methyl | Methyl |
| Phenylen | Aethyl | Aethyl | H | H |
| $(CH_3)_2C$ | Methyl | Aethyl | Methyl | Aethyl |
| $(CH_3)_2C$ | Methyl | Methyl | Methyl | Methyl |

| E | A | B | C | D |
|---|---|---|---|---|
| $(CF_3)_2C<$ | Methyl | Methyl | Methyl | Methyl |
| direkte Bindung | Methyl | Methyl | H | H |
| direkte Bindung | Methyl | Aethyl | Methyl | Aethyl |
| direkte Bindung | Methyl | Aethyl | Methyl | H |
| direkte Bindung | Aethyl | Aethyl | Aethyl | Aethyl |
| direkte Bindung | Methoxy | Methoxy | Methoxy | Methoxy |
| direkte Bindung | Isopropyl | Isopropyl | H | H |
| direkte Bindung | Methoxymethyl | Methoxymethyl | Methoxymethyl | Methoxymethyl |

X in Formel III kann auch ein unsubstituierter oder durch F oder Cl substituierter Arylenrest sein. Er kann der Formel

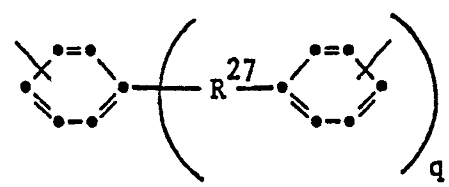

entsprechen, worin $R^{27}$ eine direkte Bindung, —O—, —S—, —SO—, $SO_2$ oder CO bedeutet und die freien Bindungen in Ortho- oder Parastellung gebunden sind und q für 0 oder 1 steht. Beispiele sind m- oder p-Phenylen, 3,3'- oder 4,4'-Bisphenylen, 3,3'- oder 4,4'-Bisphenylenäther oder -thioäther oder -benzophenon, 3,3'-Dichlorbenzidin.

Es ist bekannt, dass einige aliphatische und aromatische Diamine, z.B. Phenylendiamin oder Di(aminophenyl)methan, die Unlöslichkeit von Polyimiden fördern können. Solche Diamine werden daher bevorzugt in geringeren Mengen eingesetzt. Insbesondere sind für diesen Fall die Strukturelemente der Formel I zu mindestens 50 Mol.-%, besonders 80 Mol-% und ganz besonders 90 Mol-% enthalten.

Z enthält als vierwertiger aromatischer Rest bevorzugt 6 bis 30, besonders 6 bis 20 C-Atome. In einer bevorzugten Untergruppe entspricht Z den Formeln

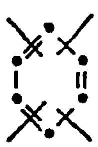 , 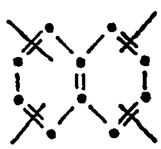 , 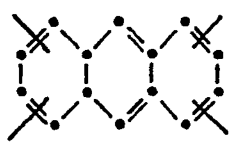 , 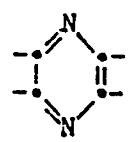 , 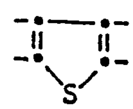

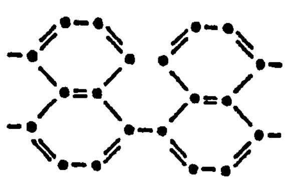 , 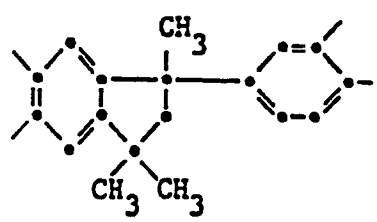 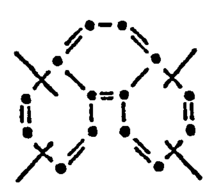 , 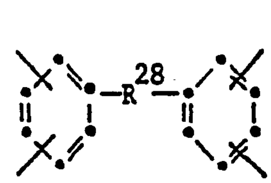

worin $R^{28}$ eine direkte Bindung oder eine Brückengruppe der Formeln

$$-O-,\quad -S-,\quad -SO_2-,\quad -\overset{O}{\overset{\|}{C}}-\overset{R^{29}}{\overset{|}{N}}-,\quad -\overset{O}{\overset{\|}{C}}-O-,\quad -\underset{R^{29}}{\underset{|}{N}}-,\quad -\overset{R^{30}}{\overset{|}{\underset{R^{31}}{\underset{|}{Si}}}}-,$$

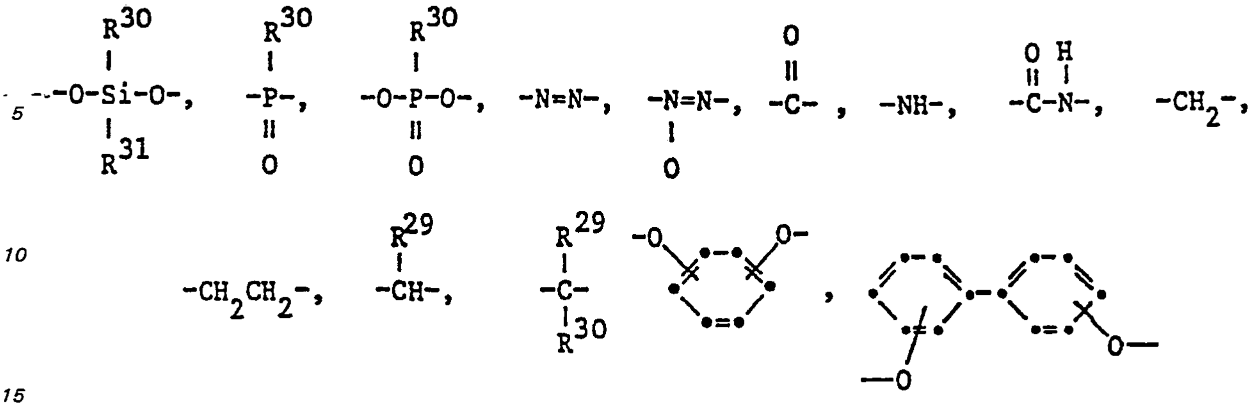

ist, worin $R^{29}$, $R^{30}$ und $R^{31}$ Alkyl mit 1 bis 6 C-Atomen, Phenyl oder Benzyl und $R^{30}$ und $R^{31}$ Alkoxy mit 1 bis 6 C-Atomen, Phenyloxy oder Benzyloxy sind.

In den vorstehenden Formeln befinden sich stets je zwei der freien Bindungen in Peri- und/oder Orthostellung.

Eine bevorzugte Untergruppe für Z sind Reste der Formeln

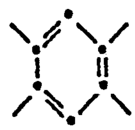 oder 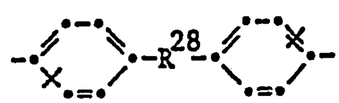

worin $R^{28}$ eine direkte Bindung, —O—, —$SO_2$—, $CH_2$ und besonders —CO— ist.

Ganz besonders bevorzugt sind Reste der Formeln

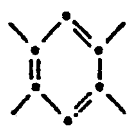 und 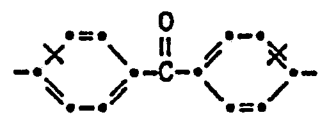

oder Mischungen davon. Die freien Bindungen im Benzophenonrest befinden sich in Orthostellung.

Beispiele für Tetracarbonsäureanhydride mit einem Rest Z sind:
2,3,9,10-Perylentetracarbonsäuredianhydrid,
1,4,5,8-Naphthalintetracarbonsäuredianhydrid,
2,6-Dichlornaphthalin-1,4,5,8-tetracarbonsäuredianhydrid,
2,7-Dichlornaphthalin-1,4,5,8-tetracarbonsäuredianhydrid,
2,3,6,7-Tetrachlornaphthalin-1,4,5,8-tetracarbonsäuredianhydrid,
Phenanthren-1,8,9,10-tetracarbonsäuredianhydrid,
Pyromellitsäuredianhydrid,
3,3',4,4'-Biphenyltetracarbonsäuredianhydrid,
2,2',3,3'-Biphenyltetracarbonsäuredianhydrid,
4,4'-Isopropylidendiphthalsäureanhydrid,
3,3'-Isopropylidendiphthalsäureanhydrid,
4,4'-Oxydiphthalsäureanhydrid,
4,4'-Sulfonyldiphthalsäureanhydrid,
3,3'-Oxydiphthalsäureanhydrid,
4,4'-Methylendiphthalsäureanhydrid,
4,4'-Thiodiphthalsäureanhydrid,
4,4'-Aethylidendiphthalsäureanhydrid,
2,3,6,7-Naphthalintetracarbonsäuredianhydrid,
1,2,4,5-Naphthalintetracarbonsäuredianhydrid,
1,2,5,6-Naphthalintetracarbonsäuredianhydrid,
Benzol-1,2,3,4-tetracarbonsäuredianhydrid,
Thiophen-2,3,4,5-tetracarbonsäuredianhydrid,
1-(3',4'-Dicarboxyphenyl)-1,3,3-trimethylindan-5,6-dicarbonsäuredianhydrid,
1-(3',4'-Dicarboxyphenyl)-1,3,3-trimethylindan-6,7-dicarbonsäuredianhydrid,
1-(3',4'-Dicarboxyphenyl)-3-methylindan-5,6-dicarbonsäuredianhydrid,
1-(3',4'-Dicarboxyphenyl)-3-methylindan-6,7-dicarbonsäuredianhydrid,

3,3',4,4'-Benzophenontetracarbonsäureanhydrid,
4,5,3',4'--Benzophenontetracarbonsäureanhydrid.

Es wurde ferner gefunden, dass in Copolyimiden eine höhere Lichtempfindlichkeit erzielt wird, wenn Z den vierwertigen Rest einer aromatischen Ketotetracarbonsäure darstellt, besonders auch wenn X ein wie zuvor definierter substituierter aromatischer Rest ist. Solche Copolyimide sind eine bevorzugte Untergruppe. Reste von solchen Ketocarbonsäuren sind besonders dann enthalten, wenn geringere Anteile an Strukturelementen der Formel I zugegen sind. Ein besonders bevorzugter Rest ist

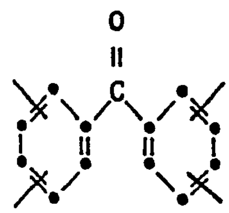

in dem die freien Bindungen in Orthostellung zueinander gebunden sind.

Weitere bevorzugte Reste von Ketocarbonsäureresten entsprechen den Formeln VIII bis XI

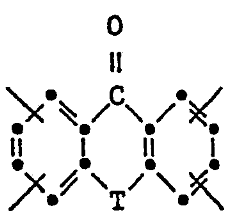

(VIII)

,

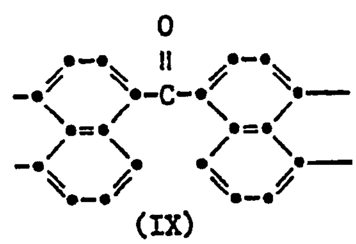

(IX)

,

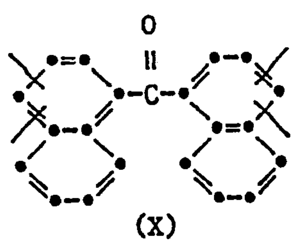

(X)

und

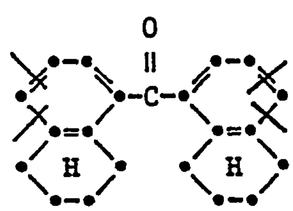

(XI)

,

worin T eine direkte Bindung, —S—, —O—, $—CH_2—$, —CO—, —NH—, $—NR^{32}—$, —SO—, $—SO_2—$, $—CHR^{32}—$, $—CR^{32}R^{33}—$ ist, und $R^{32}$ und $R^{33}$ $C_1$—$C_6$-Alkyl, Phenyl oder benzyl bedeutet und die freien Bindungen in Orthostellung zueinander gebunden sind.

Z' in Formel IIIa entspricht bevorzugt Resten der Formeln

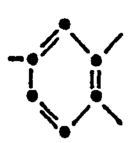

,

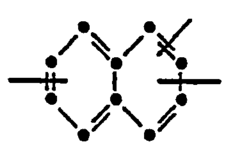

oder

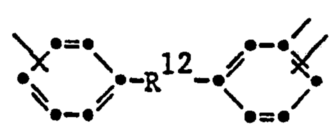

,

worin $R^{12}$ eine Brückengruppe oder eine direkte Bindung darstellt und zwei freie Bindungen in Orthostellung zueinander stehen. $R^{12}$ ist als Brückengruppe bevorzugt —O—, —S—, —CO— und $—CH_2—$ sowie Alkyliden mit 2 bis 6 C-Atomen, Cyclopentyliden und Cyclohexyliden.

Ein weiterer Gegenstand vorliegender Erfindung ist ein Verfahren zur Herstellung von Polyimiden mit Strukturelementen der Formel I gemäss Anspruch I, das dadurch gekennzeichnet, ist, dass man mindestens eine Aminodicarbonsäure der Formel IV

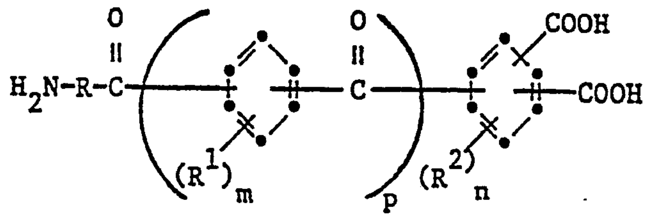 (IV),

alleine oder zusammen mit mindestens einer Aminodicarbonsäure der Formel V

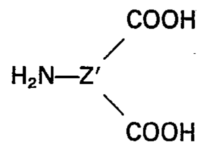 (V)

und/oder mindestens einer Tetracarbonsäure der Formel VI

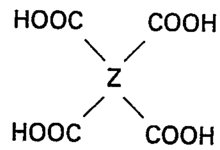 (VI)

oder deren polyimidbildenden Derivate und mindestens ein Diamin der Formel VII

$$H_2N—X—NH_2 \quad (VII),$$

worin R, $R^1$, $R^2$, Z, Z', X, m, n and p die zuvor angegebene Bedeutung haben, in an sich bekannter Weise polykondensiert und cyclisiert.

Anstelle der Tetracarbonsäuren und Aminodicarbonsäuren können auch deren Polyimid bildende Derivate verwendet werden, wie z.B. deren Ester, Amide, Halogenide, besonders die Chloride, und Anhydride.

Die Aminodicarbonsäuren der Formel IV sind neu und ein weiterer Gegenstand vorliegender Erfindung. Sie sind z.B. auf folgende Weise erhältlich:

Mellitsäure-n-butylimid wird mit $SO_2Cl_2$ in

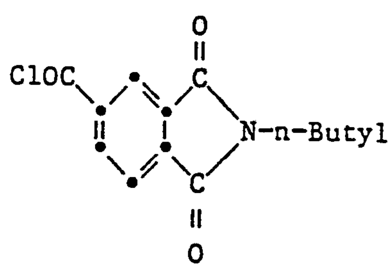

überführt und in Gegenwart von $AlCl_3$ mit

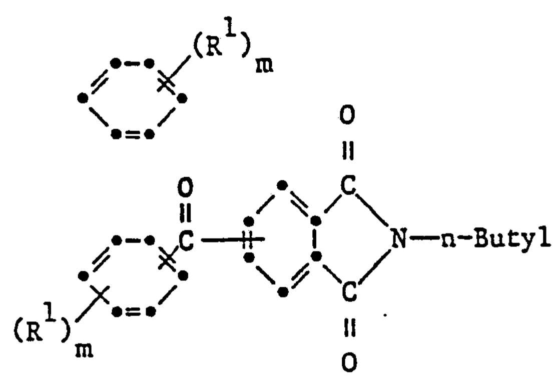

umgesetzt. Diese Verbindung wird mit $HNO_3$ nitriert und die gebildete Nitroverbindung katalytisch zur gewünschten Aminoverbindung

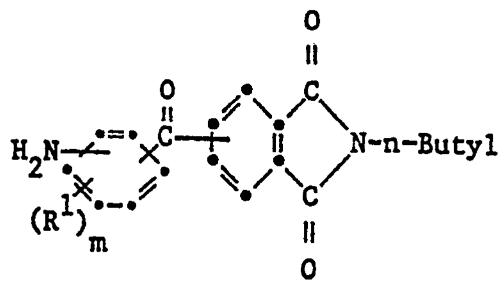

hydriert. Das Imid kann in bekannter Weise in seine Säurederivate umgewandelt werden.

4,4'-Ketobis-(naphthalin-1,2-dicarbonsäure) ist durch die Umsetzung von 2 Mol 1,2-Dimethylnaphthalin mit $COCl_2$ in Gegenwart von $AlCl_3$ und die anschliessende Oxidation des gebildeten

4,4'-Ketobis(1,2-dimethylnaphthalins) mit $HNO_3$ zur Tetracarbonsäure erhältlich. Diese Tetracarbonsäure kann partielle zum

4,4'-Keto-(tetrahydronaphthalin-1,2-dicarbonsäure) hydriert werden.

Die Hydrierung kann auch vor der Oxidation mit 4,4'-Ketobis(1,2-dimethylnaphthalin vorgenommen werden.

Tetracarbonsäuren mit Strukturelementen der Formel IV sind teilweise bekannt.

Anthrachinontetracarbonsäuren sind z.B. im US-Patent 3 702 318 und CA—100,1006119a (1984) beschrieben.

Durch Hydrierung der Ketogruppen in Anthrachinontetracarbonsäuren mit z.B. $NaBH_4$ erhält man die entsprechende Dihydroxyverbindung, die durch Behandlung mit Salzsäure am Rückfluss in Anthrontetracarbonsäure überführt werden kann. Die $CH_2$-Gruppe der Anthrontetracarbonsäure kann in bekannter Weise alkyliert und so in die $CHR^{32}$- bzw. $CR^{32}R^{33}$-Gruppe überführt werden.

Zur Herstellung von Fluorenontetracarbonsäure kann man z.B. 3,4-Dimethylmagnesiumbromid in Gegenwart von $CuCl_2$ dimerisieren und das gebildete 3,3',4,4'-Tetramethylbiphenyl mit $COCl_2$ in Gegenwart von $AlCl_3$ zum Tetramethylfluorenon umsetzen, das in bekannter Weise mit z.B. $HNO_3$ zur Tetracarbonsäure oxidiert werden kann.

Xanthontetracarbonsäure erhält man, indem man zunächst 3,3',4,4-Tetramethylphenyläther mit $CCl_4$ in Gegenwart von $AlCl_3$ und anschliessender Hydrolyse mit verdünnter HCl zu 2,3,6,7-Tetramethylxanthon umsetzt, das in üblicher Weise zur Tetracarbonsäure oxidiert wird, z.B. mit $HNO_3$.

Tetracarbonsäuren mit Strukturelementen der Formel VIII, worin T S, SO, $SO_2$ oder $NR^{32}$ bedeutet, sind auf folgendem Weg erhältlich: 1-Brom-3,4-dimethylbenzol wird mit $CCl_4$ in Gegenwart von $AlCl_3$ zum Bis-(2-Brom-3,4-dimethylphenyl)dichlormethan umgesetzt.

Die Oxidation mit 20%-iger $HNO_3$ führt zu

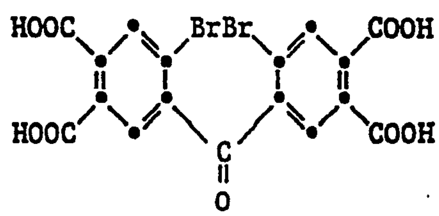

Die Umsetzung mit $Na_2S$ ergibt die Thioxanthontetracarbonsäure, die in bekannter Weise zum Sulfoxid bzw. Sulfon oxidiert werden kann. Die Umsetzung mit $NaNH_2$ oder $R^{32}NH_2$ führt zu den Acridontetracarbonsäuren.

Aminodicarbonsäuren der Formel V und Diamine der Formel VII sowie Tetracarbonsäuren der Formel VI sind bekannt, käuflich erhältlich oder nach bekannten Verfahren herstellbar. Si-haltige Diamine sind in der US—PS—3,435,002 und der EP—A—0 054 426 beschrieben. Diamine mit der

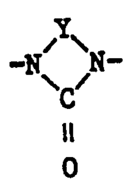

Gruppe können aus den in der DE—A—2 318 170 beschriebenen Diisocyanaten hergestellt werden. Alkyl- oder Cycloalkyl substituierte, besonders Aethyl oder Propyl substituierte Diamine sind durch Alkylierungen von unsubstituierten oder teilsubstituierten aromatischen Diaminen mit Alkenen bzw. Cycloalkenen

zugänglich (vgl. US—PS—3 275 690). Mehrkernige, besonders zweikernige aromatische Diamine sind über die Kondensation entsprechender Monoamine mit Aldehyden oder Ketonen erhältlich.

Die erfindungsgemässen Polyimide weisen mittlere Molekulargewichte (Gewichtsmittel Mw) von mindestens 2 000, vorzugsweise mindestens 5 000 auf. Die obere Grenze richtet sich im wesentlichen nach Eigenschaften, die die Verarbeitbarkeit bestimmen, wie z.B. deren Löslichkeit. Sie kann bis zu 500 000, vorzugsweise bis zu 100 000 und besonders bis zu 60 000 betragen. Es kann sich ferner um statistische Polyimide oder um Blockpolyimide handeln. Sie werden nach üblichen Verfahren in hierfür vorgesehenen Einrichtungen hergestellt. Die Reaktion wird vorteilhaft in Lösung durchgeführt; geeignete inerte Lösungsmittel sind nachfolgend genannt. Die Reaktionstemperaturen können −20 bis 300°C betragen.

Im einzelnen geht man zweckmässig so vor, dass man Aminodicarbonsäureanhydride, Tetracarbonsäuredianhydrid und Diamin zunächst unter Bildung einer Polyamidsäurevorstufe umsetzt und diese Polyamidsäure anschliessend unter Wasserabspaltung cyclisiert. Die Cyclisierung kann thermisch erfolgen. Vorteilhaft wird die Cyclisierung unter Einwirkung von wasserentziehenden Mitteln, z.B. Carbonsäureanhydriden wie Acetanhydrid, vorgenommen. Die Polyimide können anschliessend nach üblichen Verfahren, z.B. durch Entfernen des Lösungsmittels oder Ausfällen durch Zugabe eines Nichtlösungsmittels, isoliert werden.

Eine weitere Herstellungsmethode besteht darin, dass man das Tetracarbonsäuredianhydrid mit einem Diisocyanat in einer Stufe zum Polyimid umsetzt.

Die erfindungsgemässen Polyimide sind in unterschiedlichen Lösungsmitteln löslich, gegebenenfalls unter Erwärmen, und sie weisen hohe Glasumwandlungstemperaturen auf. Sie eignen sich hervorragend zur Herstellung von Filmen und Schutzüberzügen, wobei Beschichtungsmittel aus einer Lösung des Polyimides in einem Lösungsmittel Anwendung finden können. Ein weiterer Gegenstand vorliegender Erfindung ist die Verwendung der erfindungsgemässen Polyimide zur Herstellung von Schutzüberzügen und Filmen.

Zur Herstellung des beschichteten Materials löst man das Polymer oder Gemische davon zweckmässig in einem geeigneten organischen Lösungsmittel, gegebenenfalls unter Erwärmung. Geeignete Lösungsmittel sind z.B. polare, aprotische Lösungsmittel, die alleine oder in Mischungen aus mindestens zwei Lösungsmitteln verwendet werden können. Beispiele sind: Aether wie Dibutyläther, Tetrahydrofuran, Dioxan, Methylenglykol, Dimethyläthylenglykol, Dimethyldiäthylenglykol, Diäthyldiäthylenglykol, Dimethyltriäthylenglykol, halogenierte Kohlenwasserstoffe wie Methylenchlorid, Chloroform, 1,2-Dichloräthan, 1,1,1-Trichloräthan, 1,1,2,2-Tetrachloräthan, Carbonsäureester und Lactone wie Essigäureäthylester, Propionsäuremethylester, Benzoesäureäthylester, 2-Methoxyäthylacetat, γ-Butyrolacton, o-Valerolacten und Pivalolacton, Carbonsäureamide und Lactame wie Formamid, Acetamid, N-Methylformamid, N,N-Dimethylformamid, N,N-Diäthylformamid, N,N-Dimethylacetamid, N,N-Diäthylacetamid, γ-Butyrolactam, ε-Caprolactam, N-Methypyrrolidon, N-Acetylpyrrolidon, N-Methylcaprolactam, Tetramethylharnstoff, Hexamethylphosphorsäureamid, Sulofoxide wie Dimethylsulfoxid, Sulfone wie Dimethylsulfon, Diäthylsulfon, Trimethylensulfon, Tetramethylensulfon, Trimethylamin, Triäthylamin, N-Methylpyrrolidin, N-Methylpiperidin, N-Methylmorpholin, substituierte Benzole wie Chlorbenzol, Nitrobenzol, Phenole oder Kresole.

Ungelöste Anteile können durch Filtration, bevorzugt einer Druckfiltration entfernt werden. Die Konzentration an Polymer im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Antioxidantien, Lichtschutzmittel, Stabilisatoren, Farbstoffe, Pigmente Haftvermittler und Antihalofarbstoffe, wie sie z.B. in der US—PS—4 349 619 beschrieben sind.

Das Beschichtungsmittel kann mittels üblichen Methoden wie Tauch-, Streich- und Sprühverfahren, Schleuder-, Kaskadenguss- und Vorhanggussbeschichtung, auf geeignete Substrate bzw. Trägermaterialien, aufgebracht werden. Geeignete Substrate sind z.B. Kunststoffe, Metalle und Metallegierungen, Halbmetalle, Halbleiter, Glas, Keramik und andere anorganische Materialien wie z.B. $SiO_2$ und $Si_3N_4$. Danach wird das Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichtdicken bis zu ca 500 μm und mehr, bevorzugt von 0,5 bis 500 μm und besonders von 1 bis 50 μm aufweisen.

Schutzfilme aus solchen Polyimiden können durch Strahlungseinwirkung weiter modifiziert werden, womit z.B. erhöhte Thermostabilitäten möglich sind. Ferner besteht die Möglichkeit, solche Polyimide als photographisches Aufzeichnungsmaterial für Reliefabbildungen einzusetzen. Durch die Direktvernetzung unter Strahlungseinwirkung können Zusätze wie Sensibilisatoren vermieden werden und die Schutzschichten und Abbildungen weisen ausgezeichnete elektrische Eigenschaften auf. Weiter zeichnen sich die Schutzschichten und Abbildungen durch ihre hohe Thermostabilität aus sowie durch keinen oder nur einen geringen Schwund bei thermischer Belastung, was in der Anwendung erhebliche Vorteile hat, weil praktisch keine Verzerrung abgebildeter Strukturen beobachtet wird.

Ein weiterer Gegenstand der Erfindung ist ein mit solchen Polyimiden beschichtetes Trägermaterial

und die Verwendung dieses Materials zur Herstellung von Schutzschichten und photographischen Reliefabbildungen. Die Schichtdicke beträgt für diese Anwendung bevorzugt 0,5 bis 100 µm, besonders 1 bis 50 µm und insbesondere 1—10 µm.

Die Photostrukturierung bzw. Photovernetzung kann durch energiereiche Strahlung hervorgerufen werden, z.B. durch Licht insbesondere im UV-Bereich, durch Röntgenstrahlen, Laserlicht, Elektronenstrahlen usw. Das erfindungsgemässe Material eignet sich hervorragend zur Herstellung von Schutzfilmen, Passivierlacken, und als photographisches Aufzeichnungsmaterial für thermostabile Reliefabbildungen.

Anwendungsgebiete sind z.B. Schutz-, Isolier- und Passivierlacke in der Elektrotechnik und Elektronik, Photomasken für die Elektronik, den Textildruck und das graphische Gewerbe, Aetzresist zur Herstellung gedruckter Schaltungen und Druckplatten und integrierter Schaltkreise, Relais für die Herstellung von Röntgenmasken, als Löststopplack, als Dielektrikum für Mehrlagenschaltungen, als Struktelement für Flüssigkristallanzeiger.

Die Herstellung von Schutzfilmen erfolgt durch direktes Belichten, wobei sich die Belichtungszeiten im wesentlichen nach den Schichtdicken und der Lichtempfindlichkeit richten.

Die photographische Erzeugung der Reliefstruktur erfolgt durch bildmässige Belichtung durch eine Photomaske, anschliessende Entwicklung unter Entfernung der unbelichteten Anteile mit einem Lösungsmittel oder einem Lösungsmittelgemisch, wonach gegebenenfalls das erzeugte Bild durch eine thermische Nachbehandlung stabilisiert werden kann.

Ein weiterer Gegenstand der Erfindung ist ein solches Verfahren zum Aufbringen von Reliefstrukturen. Als Entwickler sind z.B. die zuvor erwähnten Lösungsmittel geeignet.

Die Polymerschicht des erfindungsgemässen Materials weist eine für viele Anwendungszwecke ausreichende und teilweise hohe Lichtempfindlichkeit auf und sie kann direkt photovernetzt werden. Die Schutzfilme und Reliefabbildungen zeichnen sich durch hohe Haftfestigkeit und thermische, mechanische und chemische Widerstandsfähigkeit aus. Bei thermischen Nachbehandlungen wird nur ein geringer Schwund beobachtet. Ferner können Zusätze zur Erzeugung bzw. Steigerung der Lichtempfindlichkeit vermieden werden. Das Material ist lagerstabil, aber vorteilhaft vor Lichteinwirkung zu schützen.

Die nachfolgenden Beispiele erläutern die Erfindung näher.

Die Glasumwandlungstemperaturen werden mit Differential-Scanning-Calometrie ermittelt.

A) Herstellung der Ausgangsprodukte

Beispiel a) Herstellung von

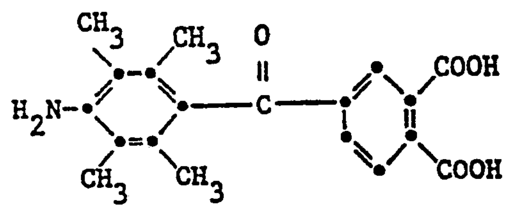

1) Zu einer Lösung von 185 g Trimellitsäureanhydrid werden im Verlaufe von 15 min. 68,5 g n-Butylamin zugetropft. Anschliessend wird auf Siedetemperatur erhitzt und ein Teil des Lösungsmittels zusammen mit dem Reaktionswasser abdestilliert. Die Restlösung wird in Wasser gegossen und das ausgefallene Produkt abfiltriert und getrocknet.

Das trockene Produkt wird dann mit 265 ml Thionylchlorid im Verlaufe einer Stunde auf Rückflusstemperatur erhitzt und noch 2 Stunden bei dieser Temperatur gehalten. Nachdem das überschüssige Thionylchlorid durch Destillation entfernt ist, wird der Rückstand aus einem Liter Cyclohexan umkristallisiert. Die Ausbeute an reinem Trimellitsäure-n-butylimid-chlorid (A) beträgt 168,9 g, FP. 77—78°C.

2) In einem Kolben werden 15,5 g Durol und 56 g $AlCl_3$ in 150 ml $CS_2$ vorgelegt und im Verlaufe von 15 min. 28 g A portionenweise zugesetzt. Nach einer Stunde wird die Mischung auf Eiswasser gegossen und 100 ml conc. HCl zugegeben.

Die organische Schicht wird abgetrennt, die wässrige Schicht mit $CH_2Cl_2$ extrahiert und die vereinigten organischen Phasen nach dem Waschen mit Wasser und Trocknen über $Na_2SO_4$ zur Trockene eingedampft. Der Rückstand wird mit 200 ml Aethanol aufgekocht, heiss filtriert und das Filtrat abgekühlt. Dabei fällt 5-(2,3,5,6-Tetramethylbenzoyl)-phthalsäure-n-butylimid (B) kristallin aus. Nach Abfiltrieren und Trocknen werden 20,5 g Produkt B mit einem Schmelzpunkt von 127°C erhalten.

Elementaranalyse:

| | berechnet | gefunden |
|---|---|---|
| C | 76.01 | 76.2 |
| H | 6.93 | 7,0 |
| N | 3,85 | 3,7 |
| O | 13,21 | 13,2 |

3) Zu einer Mischung von 48 ml $H_2SO_4$ conc. und 40 ml $HNO_3$ 65%-ig werden bei 0 bis 2°C 17 g Produkt

B portionenweise zugegeben. Nach beendeter Zugabe wird noch 2 Stunden bei 0°C gerührt, die etwas trübe Lösung filtriert und auf Eiswasser gegossen. Das ausgefällte 5-(4-Nitro-2,3,5,6-tetramethylbenzoyl)-phthalsäure-n-butylimid (C) wird abfiltriert, mit Wasser gewaschen und getrocknet und ohne weitere Reinigung in DMF mit Wasserstoff unter Katalyse von Raney-Nickel bei Normaldruck hydriert.

Die Reinigung des Hydrierungsproduktes erfolgt über eine 50 cm lange und 10 cm dicke mit Kieselgel 60 gefüllte Säule mit Toluol/Essigester (80/20) als Laufmittel. Es werden 8,9 g 5-(4-Amino-2,3,5,6-tetramethylbenzoyl)phthalsäure-n-butyl-imid (D) erhalten.

4) Zur Herstellung der freien Dicarbonsäure wird Verbindung D mit alkoholischer KOH 24 Stunden unter Rückfluss gekocht. Während dieser Behandlung fällt das Kaliumsalz allmählich mit Fortschreiten der Verseifung aus.

Das abfiltrierte Kaliumsalz wird in Wasser gelöst und tropfenweise mit 2n HCl bis zum Erreichen des isoelektrischen Punktes (pH 5—6) versetzt. Die dabei ausgefallene 5-(4-Amino-2,3,5,6-tetramethylbenzoyl)-phthalsäure (E) wird abfiltriert und getrocknet.

Elementaranalyse:

| | berechnet | gefunden |
|---|---|---|
| C | 66,85 | 65,66 |
| H | 5,61 | 5,89 |
| N | 4,10 | 4,12 |
| O | 23,44 | 24,01 |

5) 1 g Aminodicarbonsäure (E) wird im Vakuum 10 Stunden lang auf 250°C erhitzt, wobei unter Wasserabspaltung das entsprechende Anhydrid (F) gebildet wird.

Elementaranalyse:

| | berechnet | gefunden |
|---|---|---|
| C | 70,58 | 70,67 |
| H | 5,30 | 5,35 |
| N | 4,33 | 4,49 |
| O | 19,79 | 19,57 |

## Beispiel 1

Polykondensation von E

0,5 g E werden in 5 ml m-Kresol gelöst und 4 Stunden unter Rückfluss (ca. 205°C) gehalten. Die Lösung wird abgekühlt und das Polyimid mit Alkohol ausgefällt. Die inhärente Viskosität beträgt 0,41 dl/g.

## Beispiel 2

0,5 g Aminoanhydrid F werden in 5 ml NMP gelöst und 16 Stunden bei Raumtemperatur gerührt.

Anschliessend werden 0,5 ml Triäthylamin und 1,3 ml Acetanhydrid zugegeben und weitere 24 Stunden gerührt.

Das Polymer wird dann durch Einrühren in Wasser ausgefällt und getrocknet.

Inhärente Viskosität: 0,32 dl/g

Glasumwandlungstemperatur: 386°C (DSC).

## Beispiel 3

In einem Kondensationsgefäss werden 1,642 g 3,6-Diaminodurol in 22 ml N-Methylpyrrolidon (NMP) gelöst und unter Rühren 0,45 g des Aminoanhydrids F zugegeben. Nach einer Stunde werden 3,22 g Benzophenontetracarbonsäuredianhydrid (BTDA) zugesetzt. Fünf Stunden später werden weitere 32,2 mg BTDA zugegeben. Nach 2 Stunden wird die Polyamidsäurelösung mit einer Mischung von 3 ml Triäthylamin und 8,5 ml Acetanhydrid versetzt und 20 Stunden lang weitergerührt.

Die Aufarbeitung des Polyimids erfolgt durch Einrühren der Lösung in Wasser und filtrieren des ausgefallenen Produkts und Trocknen.

Inh. Viskosität: 1,04 dl/g

Tg: 430°C.

Applikationsbeispiel:

Auf einer einseitig Kupfer-kaschierten Kunststoffplatte wird ein dünner Film erzeugt, indem eine 10-%ige Lösung des Polymeren gemäss Beispiel 1 in N-Methylpyrrolidon aufgeschleudert wird, und das Lösungsmittel anschliessend im Umluftofen entfernt wird. Die so beschichtete Platte wird dann durch eine Photomaske (Stouffer-Keil) bei Raumtemperatur mit einer UV-Lampe (1000 Watt) aus einer Entfernung von 18 cm 360 sec. lang belichtet.

Die belichtete Platte wird mit N-Methylpyrrolidon entwickelt, wobei die unbelichteten Anteile weggelöst werden. Die Sichtbarmachung des Reliefbildes geschieht anschliessend durch Wegätzen der freigelegten Kupferschicht mit $FeCl_3$-Lösung.

Die Photoempfindlichkeit nach dem "21-step Stouffer sensitivity guide" beträgt 4 Stufen.

Das Copolyimid gemäss Beispiel 3 weist im gleichen Verfahren bei einer Belichtungszeit von 20 Sekunden eine Photoempfindlichkeit von 7—8 Stufen auf.

**Patentansprüche**

1. Homo- und Copolyimide, die Strukturelemente von aromatischen Aminodicarbonsäuren enthalten, mit einer inhärenten Viskosität von mindestens 0,1 dl/g, gemessen bei 25°C in einer Lösung von 0,5 Gew.% Polyimid in N-Methylpyrrolidon, dadurch gekennzeichnet, dass sie lösbar und autophotovernetzbar sind und wiederkehrende Strukturelemente der Formel I enthalten,

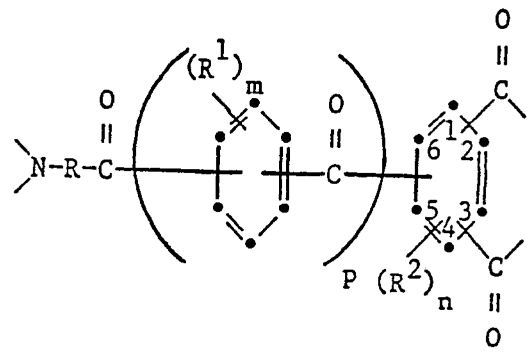

(I)

worin
$R^1$ und $R^2$ für Halogen, Nitro, Aryl, Aryloxy, Alkyl oder Alkoxy stehen, m 0 oder eine Zahl von 1—4, n 0 oder eine Zahl von 1 bis 3 und p 0, 1 oder 2 bedeuten, die freien Carbonylgruppen in Orthostellung zueinander gebunden sind, und R einen zweiwertigen aromatischen Rest bedeutet, der durch mindestens eine Alkylgruppe oder Aralkylgruppe substituiert ist.

2. Polyimide gemäss Anspruch 1, dadurch gekennzeichnet, dass m, n und p für O stehen.

3. Polyimide gemäss Anspruch 1, dadurch gekennzeichnet, dass die Carbonylgruppen in 2-, 3- und 6-Stellung gebunden sind.

4. Polyimide gemäss Anspruch 1, dadurch gekennzeichnet, dass der aromatische Rest R in mindestens einer Orthostellung zum N-Atom durch eine Alkyl oder Aralkylgruppe substituiert ist.

5. Polyimide gemäss Anspruch 1, dadurch gekennzeichnet, dass der zweiwertige aromatische Rest R durch benzyl und besonders $C_1$—$C_{12}$-Alkyl substituiert ist.

6. Polyimide gemäss Anspruch 5, dadurch gekennzeichnet, dass das Alkyl, Methyl, Ethyl oder Isopropyl ist.

7. Polyimide gemäss Anspruch 1, dadurch gekennzeichnet, dass der aromatische Rest R ein durch Alkyl substituierter Phenylen- oder Bisphenylenrest ist.

8. Polyimide gemäss Anspruch 7, dadurch gekennzeichnet, dass der Rest R der Formel II

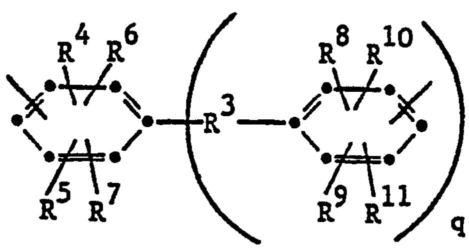

(II) ,

entspricht, worin q 0 oder 1 ist, $R^3$ eine direkte Bindung oder eine Brückengruppe bedeutet, $R^4$ Alkyl mit 1 bis 4 C-Atomen und $R^5$ bis $R^{11}$ ein Wasserstoffatom oder Alkyl mit 1 bis 4 C-Atomen sind, und die freien Bindungen in Meta- oder Parastellung zur $R^3$ Gruppe gebunden sind.

9. Polyimide gemäss Anspruch 8, dadurch gekennzeichnet, dass $R^3$ eine direkte Bindung und als Brückengruppe —S—, —SO—, —$SO_2$—, —CO—, —$CH_2$—, —O— oder $C_2$—$C_6$-Alkyliden bedeutet.

10. Polyimide gemäss Anspruch 1, dadurch gekennzeichnet, dass sie Strukturelemente der Formel

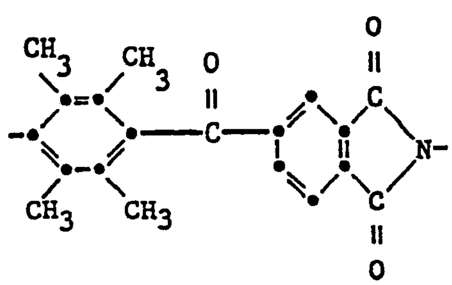

.

enthalten.

11. Lösbar und autophotovernetzbaren Polyimide gemäss Anspruch 1, dadurch gekennzeichnet, dass sie

a) 0,1—100 Mol-% Strukturelemente der Formel I und

b) 99,9—0 Mol-% aus Strukturelemente der Formeln III und/oder IIIa

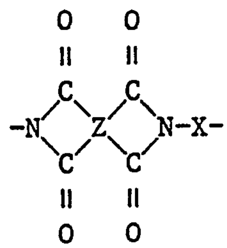

(III)

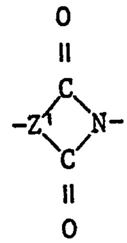

(IIIa)

worin Z der vierwertige Rest einer aromatischen Tetracarbonsäure darstellt, an den je zwei Carbonylgruppen in Ortho- oder Peristellung gebunden sind, Z' der dreiwertige, von Strukturelementen der Formel I verschiedene Rest einer aromatischen Aminocarbonsäure ist, an den zwei Carbonylgruppen in Ortho- oder Peristellung gebunden sind, und X der zweiwertige Rest eines organischen Diamines ist, enthalten.

12. Polyimide gemäss Anspruch 11, dadurch gekennzeichnet, dass Z der Formel

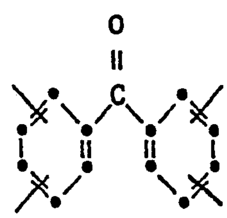

entspricht, worin die freien Bindungen in Orthostellung zueinander gebunden sind.

13. Polyimide gemäss Anspruch 11, dadurch gekennzeichnet, dass X ein zweiwertiger Phenylen- oder Bisphenylenrest ist, der in mindestens einer Orthostellung mindestens eines N-Atomes durch $C_1$—$C_{12}$-Alkyl substituiert ist.

14. Polyimide gemäss Anspruch 11, dadurch gekennzeichnet, dass Z' einen Rest der Formeln

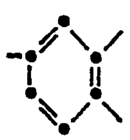 , 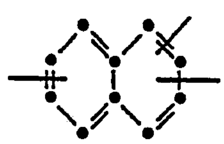 oder 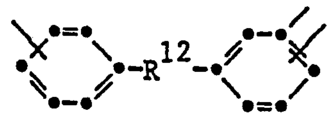 ,

bedeutet, worin $R^{12}$ eine Brückengruppe oder eine direkte Bindung ist, wobei zwei freie Bindungen in Orthostellung zueinander stehen.

15. Polyimide gemäss Anspruch 11, dadurch gekennzeichnet, dass X Alkylen, Cycloalkylen, Aralkylen oder Arylen ist.

16. Verfahren zur Herstellung von Polyimiden mit Strukturelementen der Formel I gemäss Anspruch I, dadurch gekennzeichnet, dass man mindestens eine Aminodicarbonsäure der Formel IV

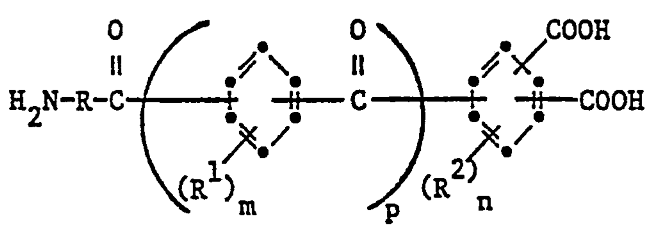

(IV),

alleine oder zusammen mit mindestens einer Amindicarbonsäure der Formel V

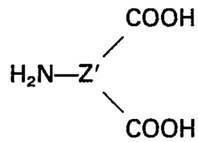

(V)

und/oder mindestens einer Tetracarbonsäure der Formel VI

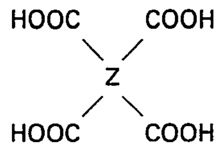

(VI)

oder deren polyimidbildenden Derivate und mindestens ein Diamin der Formel VII

$$H_2N—X—NH_2 \qquad (VII),$$

worin R, $R^1$, $R^2$, Z, Z', X, m, n and p die zuvor angegebene Bedeutung haben, in an sich bekannter Weise polykondensiert und cyclisiert.

17. Beschichtetes Material, bei dem auf mindestens einer Oberfläche eines Trägermaterials eine Schicht eines Polyimides gemäss den Ansprüchen 1 oder 11 aufgebracht ist.

18. Verwendung von Polyimiden gemäss den Ansprüchen 1 oder 11 zur Herstellung von Schutzfilmen oder photographischen Reliefabbildungen.

19. Aminodicarbonsäuren der Formel IV

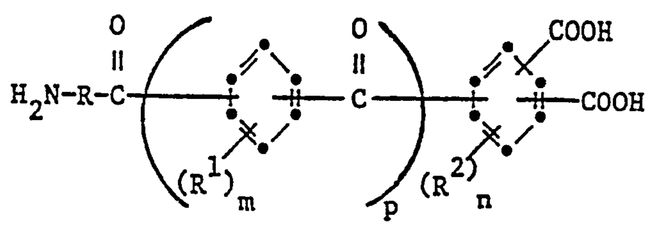

(IV),

worin

$R^1$ und $R^2$ für Halogen, Nitro, Aryl, Aryloxy, Alkyl oder Alkoxy stehen, m 0 oder eine Zahl von 1—4, n 0 oder eine Zahl von 1 bis 3 und p 0, 1 oder 2 bedeuten, die freien Carboxylgruppen in Orthostellung zueinander gebunden sind und R einen zweiwertigen aromatischen Rest bedeutet, der durch mindestens eine Alkylgruppe oder Aralkylgruppe substituiert ist, sowie ihre Säurederivate.

**Revendications**

1. Homo-polymides et copolyimides qui contiennent des unités structurales d'acides aminodicarboxyliques aromatiques et qui ont une viscosité inhérente, mesurée à 25°C sur une solution à 0,1% en poids du polyimide dans la N-méthylpyrrolidone, d'au moins 0,1 dl/g, polyimides caractérisés en ce qu'ils sont solubles et autophotoréticulables et contiennent des éléments structuraux répétés qui répondent à la formule I:

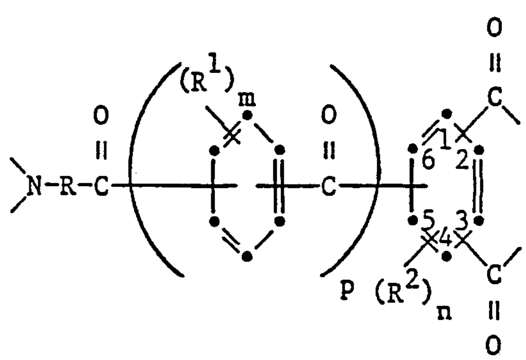

(I)

dans laquelle

$R^1$ et $R^2$ représentent chacun un halogène ou un radical nitro, aryle, aryloxy, alkyle ou alcoxy,

m désigne un nombre de 0 à 4,
n désigne un nombre de 0 à 3,
p est égal à 0, à 1 ou à 2,
les carbonyles libres sont en position ortho l'un par rapport à l'autre, et
R représente un radical aromatique bivalent qui porte au moins un alkyle ou un aralkyle.

2. Polyimides selon la revendication 1, caractérisés en ce que m, n et p sont égaux chacun à 0.

3. Polyimides selon la revendication 1, caractérisé en ce que les radicaux carbonyles se trouvent aux postions 2, 3 et 6.

4. Polyimides selon la revendication 1, caractérisés en ce que le radical aromatique R porte un radical alkyle ou aralkyle en au moins une position ortho par rapport à l'atome d'azote.

5. Polyimides selon la revendication 1, caractérisés en ce que le radical aromatique bivalent R porte un benzyle et, plus particulièrement, un alkyle en $C_1$—$C_{12}$.

6. Polyimides selon la revendication 5, caractérisés en ce que l'alkyle est un radical méthyl, éthyl ou isopropyle.

7. Polyimides selon la revendication 1, caractérisés en ce que le radical aromatique R est un radical phénylène ou biphénylylène porteur d'un alkyle.

8. Polyimides selon la revendication 7, caractérisés en ce que le radical R répond à la Formule II:

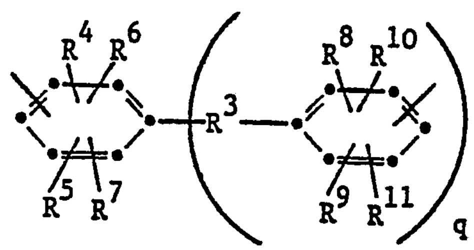

(II) ,

dans laquelle q est égal à 0 ou à 1, $R^3$ représente une liaison directe ou un radical formant pont, $R^4$ représente un alkyle contenant de 1 à 4 atomes de carbone, $R^5$ à $R^{11}$ représentent chacun un atome d'hydrogène ou un alkyle contenant de 1 à 4 atomes de carbone, et les liaisons libres sont en position méta ou para relativement au radical $R^3$.

9. Polyimides selon la revendication 8, caractérisés en ce que $R^3$ représente une liaison directe ou, en tant que radical pont, —S—, —SO—, —$SO_2$—, —CO—, —$CH_2$—, —O— ou un alkylidène en $C_2$—$C_6$.

10. Polyimides selon la revendication 1, caractérisés en ce qu'ils contiennent des unités structurales de Formule:

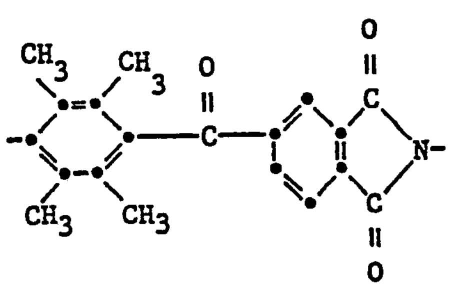

.

11. Polyimides solubles et autophotoréticulables selon la revendication 1, caractérisés en ce qu'ils contiennent:

a) de 0,1 à 100% en moles d'unités structurales de Formule I et

b) de 99,9 à 0% en moles d'unités structurales de Formule III et/ou IIIa

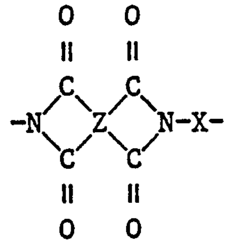

(III)

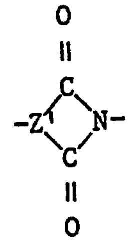

(IIIa)

dans lesquelles Z représente le radical quadrivalent d'un acide tétracarboxylique aromatique sur lequel les deux éléments de chacun des groupes carbonyle sont en position ortho ou péri, Z' représente le radical trivalent, différent des éléments structuraux de formule I, d'un acide aminocarboxyique aromatique, radical auquel sont liés deux radicaux carbonyle en position ortho ou péri, et X représente le radical bivalent d'une diamine organique.

12. Polyimides selon la revendication 11, caractérisés en ce que Z répond à la Formule:

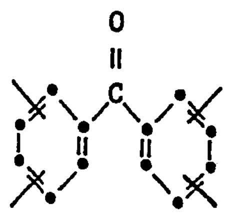

les liaisons libres étant en position ortho l'une par rapport à l'autre.

13. Polyimides selon la revendication 11, caractérisés en ce que X représente un radical phénylène ou biphénylène bivalent qui porte un alkyle en $C_1$—$C_{12}$ en au moins une position ortho par rapport à au moins un atome d'azote.

14. Polyimides selon la revendication 11, caractérisés en ce que Z' représente un radical répondant à l'une des Formules suivantes:

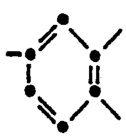 , 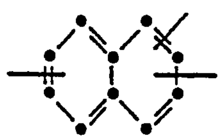 oder 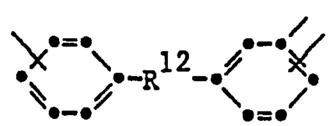 ,

où $R^{12}$ représente un radical formant pont ou une liaison directe, deux liaisons libres étant en position ortho l'une par rapport à l'autre.

15. Polyimides selon la revendication 11, caractérisés en ce que X représente un radical alkylène, cycloalkylène, aralkylène ou arylène.

16. Procédé pour préparer des polyimides renfermant des unités structurales de Formule I selon la revendication 1, procédé caractérisés en ce qu'on polycondense et cyclise, de manière connue, au moins un acide aminodicarboxylique de Formule IV:

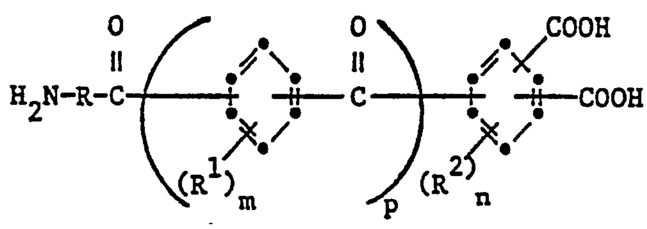 (IV),

seul ou avec au moins un acide aminodicarboxylique de Formule V:

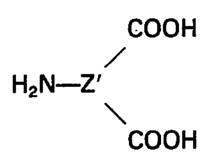 (V)

et/ou au moins un acide tétracarbocyclique de Formule VI:

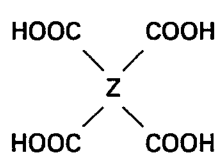 (VI)

ou leurs dérivés générateurs de polyimides, et au moins une diamine de Formule VII:

$$H_2N—X—NH_2 \qquad (VII),$$

formules dans lesquelles R, $R^1$, $R^2$, Z, Z', X, m, n et p ont les significations qui leur ont été données ci-dessus.

17. Matière revêtue sur laquelle une couche d'un polyimide selon l'une des revendications 1 et 11 est appliquée sur au moins une surface d'une matière support.

18. Emploi de polyimides selon l'une des revendications 1 et 11 pour la fabrication de pellicules protectrices ou d'images photographiques en relief.

19. Acides aminodicarboxyliques répondant à la Formule IV:

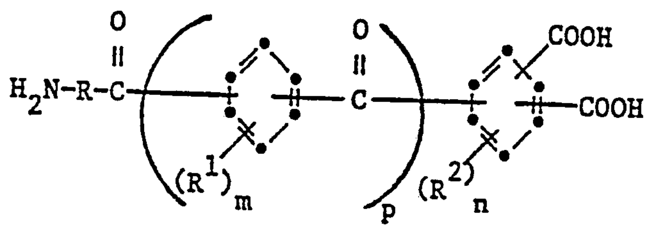

(IV),

dans laquelle

$R^1$ et $R^2$ représentent chacun un halogène ou un radical nitro, aryle, aryloxy, alkyle ou alcoxy, m désigne un nombre de 0 à 4, n désigne un nombre de 0 à 3, p est égal à 0, à 1 ou à 2, les radicaux carboxy libres sont en position ortho l'un par rapport à l'autre, et R représente un radical aromatique bivalent porteur d'au moins un radical alkyle ou aralkyle, ainsi que leurs dérivés des fonctions acides.

## Claims

1. A homopolyimide or copolyimide which contains structural elements of aromatic aminodicarboxylic acids and has an intrinsic viscosity of at least 0.1 dl/g, measured at 25°C in a solution of 0.5% by weight of polyimide in N-methylpyrrolidone, which is soluble and autophoto-cross-linkable and contains recurring structural elements of the formula I

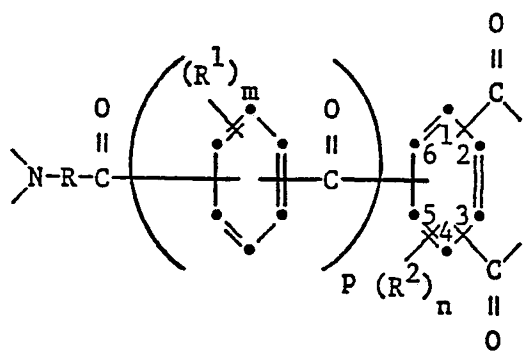

(I)

in which $R^1$ and $R^2$ are halogen, nitro, aryl, aryloxy, alkyl or alkoxy, m is 0 or a number from 1 to 4, n is 0 or a number from 1 to 3 and p is 0, 1 or 2, the free carbonyl groups are bonded in the ortho-position relative to one another and R is a divalent aromatic radical which is substituted by at least one alkyl group or aralkyl group.

2. A polyimide according to claim 1, wherein m, n and p are 0.

3. A polyimide according to claim 1, wherein the carbonyl groups are bonded in the 2-, 3- and 6-position.

4. A polyimide according to claim 1, wherein the aromatic radical R is substituted by an alkyl or aralkyl group in at least one ortho-position relative to the N atom.

5. A polyimide according to claim 1, wherein the divalent aromatic radical R is substituted by benzyl and, in particular, $C_1—C_{12}$ alkyl.

6. A polyimide according to claim 5, wherein the alkyl is methyl, ethyl or isopropyl.

7. A polyimide according to claim 1, wherein the aromatic radical R is a phenylene or bisphenylene radical substituted by alkyl.

8. A polyimide according to claim 7, wherein the radical R has the formula II

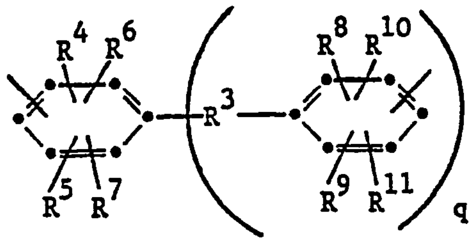

(II) ,

in which q is 0 or 1, $R^3$ is a direct bond or a bridge group, $R^4$ is alkyl having 1 to 4 C atoms and $R^5$ to $R^{11}$ are a hydrogen atom or alkyl having 1 to 4 C atoms, and the free bonds are in the meta- or para-position relative to the $R^3$ group.

9. A polyimide according to claim 8, wherein $R^3$ is a direct bond or, as a bridge member, —S—, —SO—, —$SO_2$—, —CO—, —$CH_2$—, —O— or $C_2$—$C_6$ alkylidene.

10. A polyimide according to claim 1, which contains structural elements of the formula

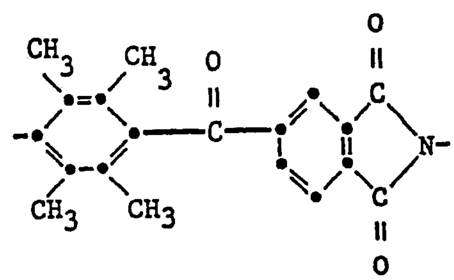

.

11. A soluble and autophotocrosslinkable polyimide according to claim 1, which contains
a) 0.1—100 mol% of structural elements of the formula I and
b) 99.9—0 mol% of structural elements of the formula III and/or IIIa

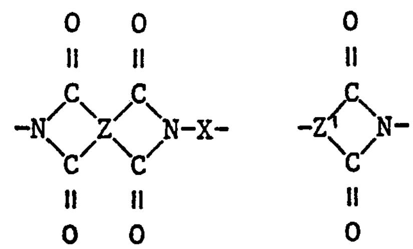

(III) (IIIa)

in which Z is the tetravalent radical of an aromatic tetracarboxylic acid onto which in each case two carbonyl groups are bonded in the ortho- or peri-position, Z' is the trivalent radical of an aromatic aminocarboxylic acid, which radical is different from structural elements of the formula I and onto which two carbonyl groups are bonded in the ortho- or peri-position and X is the divalent radical of an organic diamine.

12. A polyimide according to claim 11, wherein Z has the formula

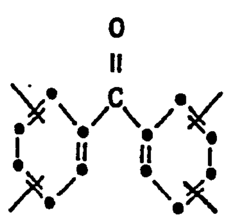

in which the free bonds are in the ortho-position relative to one another.

13. A polyimide according to claim 11, wherein X is a divalent phenylene or bisphenylene radical which is substituted by $C_1$—$C_{12}$ alkyl in at least one ortho-position relative to at least one N atom.

14. A polyimide according to claim 11, wherein Z' is a radical of the formula

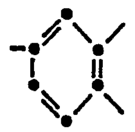 , 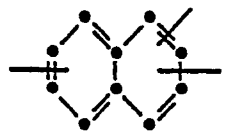 oder 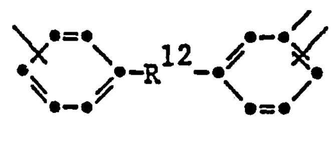 ,

in which $R^{12}$ is a bridge group or a direct bond, two free bonds being in the ortho-position relative to one another.

15. A polyimide according to claim 11, wherein X is alkylene, cycloalkylene, aralkylene or arylene.

16. A process for the preparation of a polyimide having structural elements of the formula I according to claim 1, which comprises subjecting at least one aminodicarboxylic acid of the formula IV

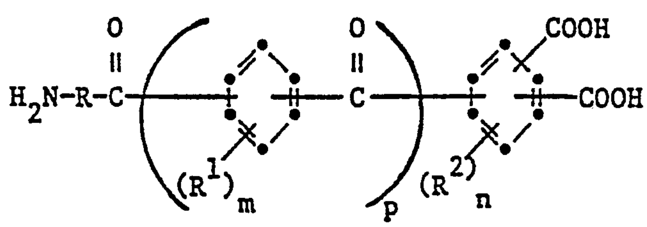 (IV),

by itself or together with at least one aminodicarboxylic acid of the formula V

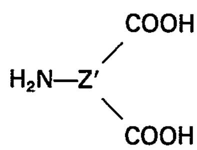 (V)

and/or at least one tetracarboxylic acid of the formula VI

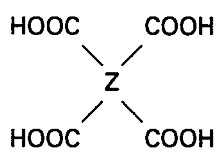 (VI)

or polyimide-forming derivatives thereof, and at least one diamine of the Formula VII

$$H_2N—X—NH_2 \quad (VII)$$

in which R, $R^1$, $R^2$, Z, Z', X, m, n and p are as defined above, to polycondensation and cyclisation in a manner which is known per se.

17. A coated material, in which a layer of a polyimide according to either of claims 1 and 11 is applied to at least one surface of a carrier material.

18. The use of a polyimide according to either of claims 1 and 11 for the production of protective films or photographic relief images.

19. An aminodicarboxylic acid of the formula IV

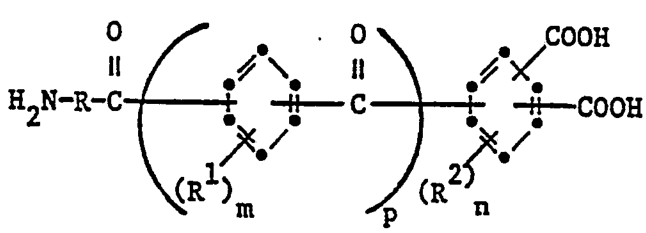 (IV),

in which $R^1$ and $R^2$ are halogen, nitro, aryl, aryloxy, alkyl or alkoxy, m is 0 or a number from 1 to 4, n is 0 or a number from 1 to 3 and p is 0, 1 or 2, the free carboxyl groups are bonded in the ortho-position relative to one another and R is a divalent aromatic radical which is substituted by at least one alkyl group or aralkyl group, and its acid derivatives.